# EUROPEAN PATENT APPLICATION

(11) **EP 3 565 390 A1**
(43) Date of publication of application: **06.11.2019**
(21) Application number: 17889009.1
(22) Date of filing: 25.12.2017
(51) Int. Cl.: H05K 3/10, H05K 1/02

(54) **WIRING SUBSTRATE AND WIRING SUBSTRATE MANUFACTURING METHOD**

(30) Priority: 28.12.2016 JP 2016256642
(71) Applicant: Fujikura Ltd., Tokyo 135-8512 (JP)
(72) Inventor: KAIZU, Masahiro, Sakura-shi, Chiba 285-8550 (JP)
(74) Representative: Ter Meer Steinmeister & Partner
(86) International application number: PCT/JP2017/046441
(87) International publication number: WO 2018/123977

(57) **Abstract**

A wiring board 1 includes: a support body 10 including at least one woven fabric 11 woven from weaving yarns 12 and 13 each formed by bundling insulating fibers 121 and 131; and a conductive body 20 supported by the support body 10, the conductive body 20 includes a first conductive path 21 which is provided on a first main face 101 of the support body 10 and extends in a planar direction of the first main face 101, and the first conductive path 21 includes at least one of a first conductor portion 211 which exists in a basket hole 14 of the woven fabric 11 and a first intervening portion 212 which exists in a gap between the insulating fibers 121 and 131.

## Description

### TECHNICAL FIELD

The present invention relates to a wiring board and a method of manufacturing a wiring board.

For designated countries that are permitted to be incorporated by reference in the literature, the content described in Japanese Patent Application No. 2016-256642 filed in Japan on December 28, 2016 is incorporated herein by reference and is regarded as a part of the description of this specification.

### BACKGROUND ART

As wiring boards having flexibility, there are known a flexible printed wiring board (FPC) obtained by forming a circuit layer by etching or plating on a film and a membrane wiring board obtained by forming a circuit layer by printing a silver paste on a film (refer to, for example, Paragraph [0002] in Patent Document 1). As a use application of such a wiring board, there is known, for example, a wearable application in a broad sense such as a seating sensor provided in a seat of an automobile (refer to, for example, Paragraph [0002] in Patent Document 2).

### CITATION LIST

### PATENT DOCUMENT

Patent Document 1: JP 2011-014742 A
Patent Document 2: JP 2015-046226 A

### SUMMARY OF THE INVENTION

### PROBLEM TO BE SOLVED BY THE INVENTION

The FPC or the membrane wiring board described above is excellent in a followability to a bent shape centered on one axis such as a U shape. However, with respect to deformation of a three-dimensional shape of such a spherical surface, there is a problem that the followability remarkably deteriorates due to the tension of the film. For example, in the seating sensor disposed in a gap between the skin and the cushion foam of the seat of the automobile, an occupant may feel uncomfortable due to unnatural rigidity and abnormal sound.

The problem to be solved by the invention is to provide a wiring board excellent in followability to three-dimensional deformation and a method of manufacturing the wiring board.

### MEANS FOR SOLVING PROBLEM

[1] A wiring board according to the invention is a wiring board including: a support body including at least one woven fabric woven from weaving yarns each formed by bundling insulating fibers; and a conductive body supported by the support body, in which the conductive body includes a first conductive path which is provided on a first main face of the support body and extends in a planar direction of the first main face, and the first conductive path has at least one of a first conductor portion and a first intervening portion, the first conductor portion existing in a basket hole of the woven fabric, and the first intervening portion existing in a gap between the insulating fibers.
[2] In the above-described invention, the conductive body may include a second conductive path which is provided on a second main face of the support body and extends in a planar direction of the second main face, the second conductive path may have: a second conductor portion which exists in the basket hole of the woven fabric; and a second intervening portion which exists in a gap between the insulating fibers, at least a portion of the first conductor portions and at least a portion of the second conductor portions may be integrated with each other or bonded to each other, and the first conductive path and the second conductive path may be electrically connected to each other via the first conductor portion and the second conductor portion.
[3] In the above-described invention, the insulating fiber may include at least one of a glass fiber and a resin fiber.
[4] In the above-described invention, the weaving yarn may be formed by bundling single type or plural types of insulating fibers.
[5] In the above-described invention, the weaving yarns may include: warp yarns which extend in a first direction; and weft yarns which are weaving yarns of which type is the same as or different from a type of the warp yarns and extends in a second direction intersecting the first direction.
[6] In the above-described invention, the support body may include woven fabrics stacked on each other, and the woven fabrics may be the same type of woven fabric or plural types of woven fabrics.
[7] In the above-described invention, the wiring board may further include a first insulating layer which covers the conductive body and exists in the support body.
[8] In the above-described invention, the first insulating layer may have a window portion which exposes a portion of the conductive body to an outside.
[9] In the above-described invention, the conductive body may contain a single type or plural types of metals.
[10] In the above-described invention, at least one of the first conductive path and the second conductive path may include conductive layers stacked on each other.
[11] In the above-described invention, the conductive layers may include at least one plating layer.
[12] In the above-described invention, the wiring board may include a second insulating layer which closes the basket hole from at least one of the second main face side and the first main face side of the support body.
[13] In the above-described invention, the support body may have a third insulating layer which is provided so as to extend in the interior of the support body and closes the basket hole.
[14] A method of manufacturing a wiring board according to the invention is a method of manufacturing a wiring board including: a first process of preparing a support body including at least one woven fabric woven from weaving yarns each formed by bundling insulating fibers; and a second process of supporting a conductive body by the support body, in which the second process includes: a first step of forming a precursor containing at least one of metal particles and metal oxide particles on the support body by coating a dispersion liquid containing at least one of the metal particles and the metal oxide particles on at least one of a first main face and a second main face of the support body; and a second step of forming a sintered body having conductivity by irradiating the precursor with pulsed electromagnetic waves, and the first step includes forming the precursor so that the precursor exists in at least one of a basket hole of the woven fabric and a gap between the insulating fibers.
[15] In the above-described invention, the insulating fiber may include at least one of a glass fiber and a resin fiber.
[16] In the above-described invention, the weaving yarns may include: warp yarns which extend in a first direction; and weft yarns which are weaving yarns of which type is the same as or different from a type of the warp yarns and extends in a second direction intersecting the first direction.
[17] In the above-described invention, the support body may be include woven fabrics stacked on each other, and the woven fabrics may be the same type of woven fabric or plural types of woven fabrics.
[18] In the above-described invention, the second process may include a third step of compressing the sintered body.
[19] In the above-described invention, the second process may include forming a plating layer on the sintered body after the second step or the third step.
[20] In the above-described invention, the method may further include a third process of forming a first insulating layer which covers the conductive body and exists in the support body.
[21] In the above-described invention, the first insulating layer may have a window portion which exposes a portion of the conductive body to an outside.
[22] In the above-described invention, the conductive body may contain a single type or plural types of metals.
[23] In the above-described invention, the first step may include coating the dispersion liquid on at least one of the first and second main faces plural times.
[24] In the above-described invention, the first process may include forming a second insulating layer on the support body, the second insulating layer closing the basket hole from at least one of the second main face side and the first main face side of the support body.
[25] In the above-described invention, the first process may include forming a third insulating layer in the support body, the third insulating layer being provided so as to extend in the interior of the support body and closing the basket hole.
[26] A method of manufacturing a wiring board according to the invention is a method of manufacturing a wiring board including: a first process of preparing a support body including at least one woven fabric woven from weaving yarns formed by bundling insulating fibers; and a second process of supporting a conductive body by the support body, in which the second process includes: a first step of coating a conductive ink containing conductive particles and a binder resin on at least one of a first main face and a second main face of the support body; and a second step of forming a fired body having conductivity by applying thermal energy to the conductive ink, and the first step includes coating the conductive ink so that the conductive ink exists in at least one of a basket hole of the woven fabric and a gap between the insulating fibers.
[27] In the above-described invention, the insulating fiber may include at least one of a glass fiber and a resin fiber.
[28] In the above-described invention, the weaving yarns may include: warp yarns which extend in a first direction; and weft yarns which are weaving yarns of which type is the same as or different from a type of the warp yarns and extends in a second direction intersecting the first direction.
[29] In the above-described invention, the support body may be include woven fabrics stacked on each other, and the woven fabrics may be the same type of woven fabric or plural types of woven fabrics.
[30] In the above-described invention, the second process may include forming a plating layer on the fired body after the second step.
[31] In the above-described invention, the method may further include a third process of forming a first insulating layer which covers the conductive body and exists in the support body.
[32] In the above-described invention, the first insulating layer may have a window portion which exposes a portion of the conductive body to an outside.
[33] In the above-described invention, the conductive body may contain a single type or plural types of metals.
[34] In the above-described invention, the first step may include coating the dispersion liquid on at least one of the first and second main faces plural times.
[35] In the above-described invention, the first process may include forming a second insulating layer on the support body, the second insulating layer closing the basket hole from at least one of the second main face side and the first main face side of the support body.
[36] In the above-described invention, the first process may include forming a third insulating layer in the support body, the third insulating layer being provided so as to extend in the interior of the support body and closing the basket hole.

### EFFECT OF THE INVENTION

According to the invention, the support body includes at least one woven fabric, and the first conductive path has at least one of the first conductor portion existing in the basket hole and the first intervening portion existing in the gap between the insulating fibers. For this reason, while the adhesiveness between the support body and the conductive body is maintained by the first conductor portion or the first intervening portion, it is possible to ensure excellent followability to the three-dimensional deformation due to the flexibility of the woven fabric in the portion of the support body where the conductive body does not exist.

According to the invention, the support body includes at least one woven fabric, and in the second process, the precursor or the conductive ink exists in at least one of the basket hole of the woven fabric and the gap between the insulating fibers. For this reason, while the adhesiveness between the support body and the conductive body is maintained by the first conductor portion or the first intervening portion, it is possible to ensure excellent followability to the three-dimensional deformation due to the flexibility of the woven fabric in the portion of the support body where the conductive body does not exist.

### BRIEF DESCRIPTION OF DRAWINGS

Fig. 1 is a perspective view illustrating a wiring board in a first embodiment of the invention;
Fig. 2 is a cross-sectional view taken along line II-II of Fig. 1;
Fig. 3 is an enlarged view of a portion III of Fig. 2;
Fig. 4 is a plan view of a woven fabric used as a support body of the wiring board illustrated in Fig. 1;
Fig. 5 is a cross-sectional view taken along line V-V of Fig. 4;
Fig. 6 is a cross-sectional view taken along line VI-VI of Fig. 4;
Fig. 7 is a cross-sectional view illustrating a modified example of the support body in the first embodiment of the invention;
Fig. 8 is a cross-sectional view illustrating a modified example of a conductive body in the first embodiment of the invention;
Fig. 9 is a perspective view illustrating a wiring board in a second embodiment of the invention;
Fig. 10 is a cross-sectional view taken along line X-X of Fig. 9;
Fig. 11 is a cross-sectional view illustrating a modified example of a support body in the second embodiment of the invention;
Fig. 12 is a cross-sectional view illustrating another modified example of the support body in the second embodiment of the invention;
Fig. 13 is a cross-sectional view illustrating a wiring board in a third embodiment of the invention;
Fig. 14 is a cross-sectional view of a portion XIV of Fig. 13;
Fig. 15 is a cross-sectional view illustrating a modified example of the wiring board in the third embodiment of the invention;
Fig. 16 is a process chart illustrating a method of manufacturing a wiring board by a photosintering process in the first embodiment of the invention;
Fig. 17(a) is a cross-sectional view illustrating step S10 of Fig. 16, and Figs. 17(b) to 17(e) are cross-sectional views illustrating step S20 of Fig. 16;
Figs. 18(a) to 18(d) are cross-sectional views illustrating step S20 of Fig. 16;
Fig. 19(a) is a cross-sectional view illustrating step S30 of Fig. 16, and Fig. 19(b) is a cross-sectional view illustrating step S40 of Fig. 16;
Figs. 20(a) and 20(b) are cross-sectional views illustrating step S50 of Fig. 16;
Fig. 21 is a process chart illustrating a method of manufacturing a wiring board by using a conductive ink in the first embodiment of the invention;
Fig. 22(a) is a cross-sectional view illustrating step S110 of Fig. 21, Figs. 22(b) to 22(d) are cross-sectional views illustrating step S120A of Fig. 21, and Figs. 22(e) and 22(f) are cross-sectional views illustrating step S130A of Fig. 21;
Figs. 23(a) to 23(c) are cross-sectional views illustrating step S120B of Fig. 21, and Figs. 23(d) and 23(e) are cross-sectional views illustrating step S130B of Fig. 21;
Figs. 24(a) and 24(b) are cross-sectional views illustrating step S140 of Fig. 21; and
Figs. 25(a) and 25(b) are cross-sectional views illustrating a modified example of step S140 of Fig. 21.

### MODE(S) FOR CARRYING OUT THE INVENTION

Hereinafter, embodiments of the invention will be described with reference to the drawings.

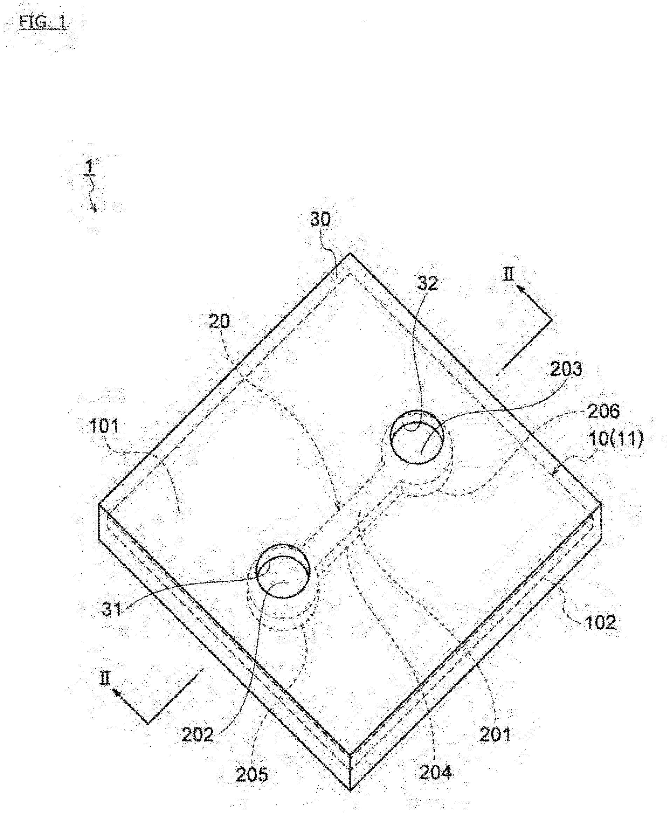

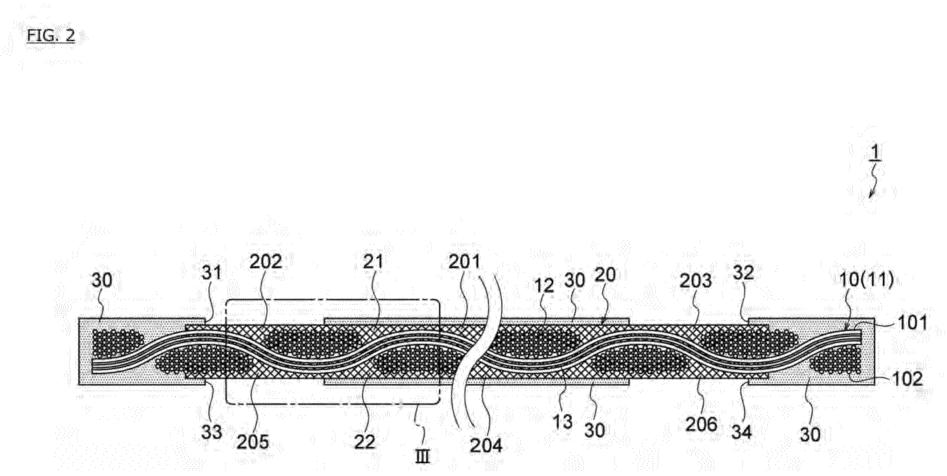

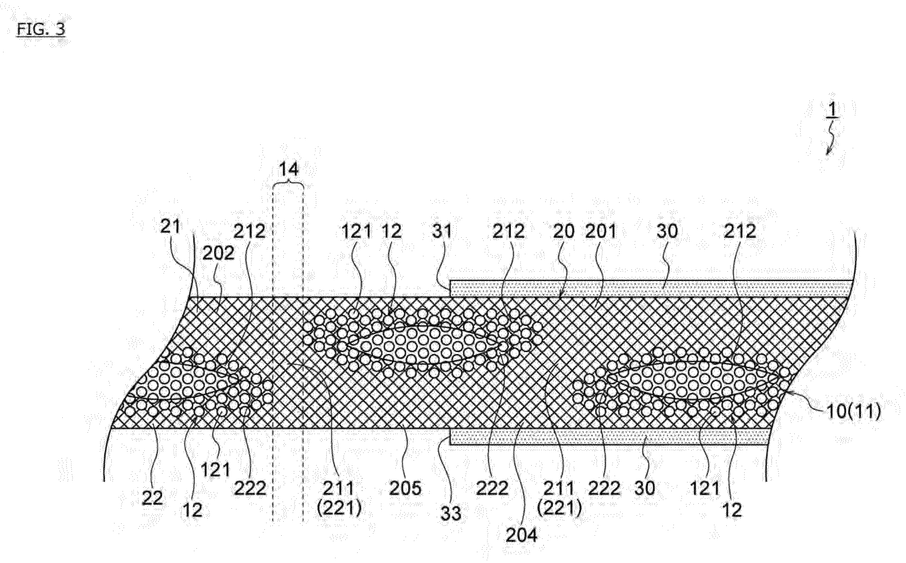

Fig. 1 is a perspective view illustrating a wiring board in a first embodiment of the invention, Fig. 2 is a cross-sectional view taken along line II-II of Fig. 1, and Fig. 3 is an enlarged view of a portion III of Fig. 2. Fig. 3 is not an exact enlarged view of the portion III of Fig. 2, but Fig. 3 illustrates a cross-sectional view in a case where a cross section of Fig. 2 is parallel-translated to a basket hole 14 for the better understanding of the structure of first and second conductor portions 211 and 221 (described later) of first and second conductive paths 21 and 22.

As illustrated in Figs. 1 to 3, a wiring board 1 in the first embodiment of the invention includes a support body 10, a conductive body 20 supported by the support body 10, and a first insulating layer 30 that covers the support body 10 and the conductive body 20. The support body 10 in the embodiment corresponds to an example of the support body in the invention, and the conductive body 20 in the embodiment corresponds to an example of the conductive body in the invention, and the first insulating layer 30 in the embodiment corresponds to an example of the first insulating layer in the invention.

As use applications of the wiring board 1, applications requiring a peculiar texture, complicated or precise stereoscopic (three-dimensional) shape may be exemplified, and as specific examples, circuits installed on a steering wheel or a skin of a seat of an automobile, circuits installed on a mirror or a bumper of an automobile, or the like may be exemplified. The use application of the wiring board according to the invention is not particularly limited to the above-described applications. For example, the wiring board 1 may be used for so-called wearable applications such as biometric information sensors provided in attached items of clothes, hats, or the like and various detection sensors provided in medical care bedding, or the like. Alternatively, the wiring board according to the invention may be used as an inner layer of a multilayer printed wiring board. The wiring board 1 may not have the first insulating layer 30 according to the use application of the wiring board 1.

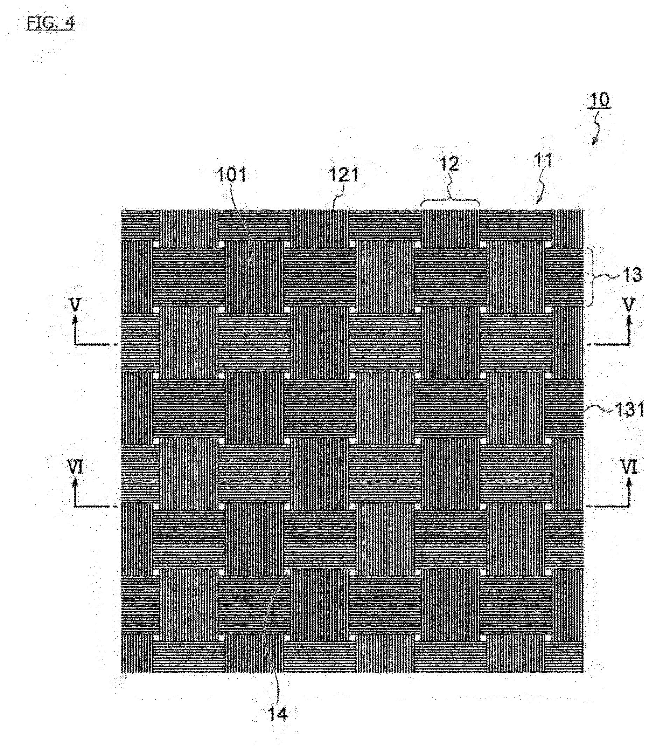

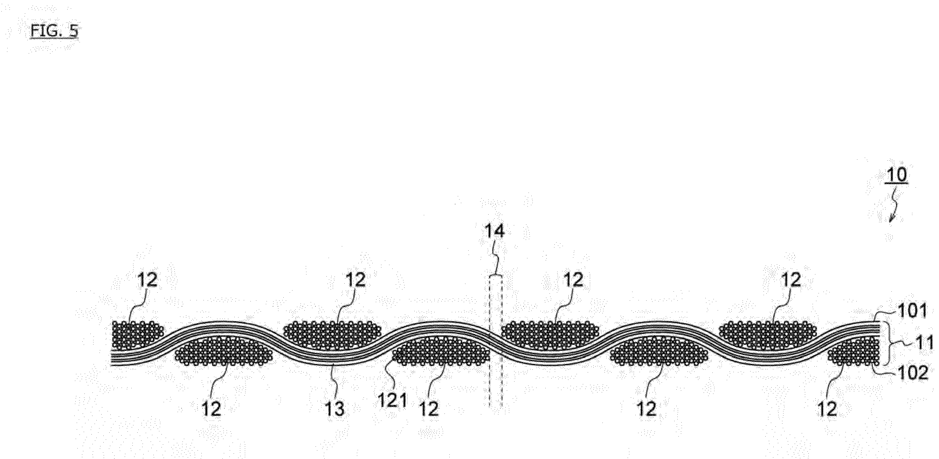

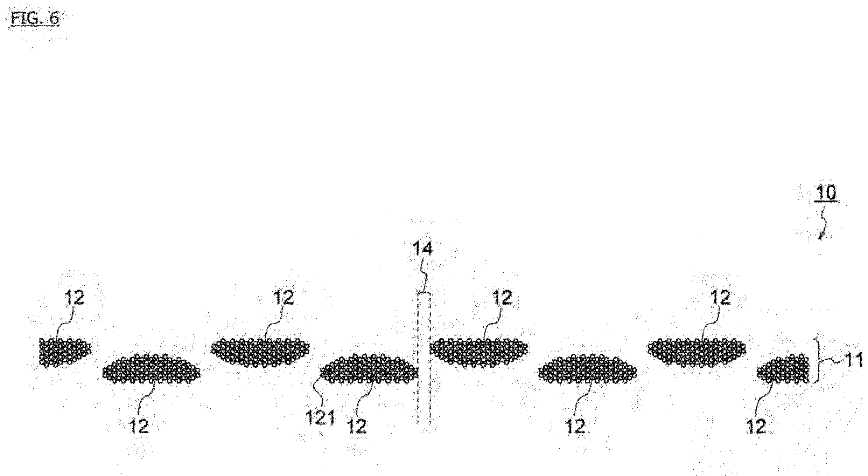

Fig. 4 is a plan view of a woven fabric used as a support body, Fig. 5 is a cross-sectional view taken along line V-V of Fig. 4, and Fig. 6 is a cross-sectional view taken along line VI-VI of Fig. 4.

The support body 10 is configured with a single sheet of the woven fabric 11 having flexibility, which is woven by weaving the weaving yarns 12 and 13 with plain weave. As illustrated in Figs. 4 to 6, the weaving yarns constituting the woven fabric 11 include warp yarns 12 extending in the longitudinal direction and weft yarns 13 extending in a direction (that is, lateral direction) substantially perpendicular to the warp yarns 12.

As described above, since the woven fabric 11 is formed by weaving the weaving yarns 12 and 13 in a lattice shape, the woven fabric has a plurality of basket holes 14. The basket hole 14 is an opening (mesh) surrounded by the warp yarns 12 and the weft yarns 13 and penetrates the woven fabric 11 in the thickness direction of the woven fabric 11. The plurality of basket holes 14 have substantially the same shape and substantially the same opening area and are regularly and uniformly arranged in the woven fabric 11 in plan view.

The shape, opening area, arrangement interval, and the like of the basket hole 14 depend on the diameter of the insulating fibers 121 and 131, the number of the insulating fibers 121 and 131 constituting the weaving yarns 12 and 13, the density of the insulating fibers 121 and 131 constituting the weaving yarns 12 and 13, and the method of weaving the woven fabric 11, and the like. However, the shape, opening area, arrangement interval, and the like of the basket hole may be determined on the basis of the mechanical characteristics and the electrical characteristics required for the wiring board 1.

Each of the warp yarns 12 is formed by bundling about 10 to 200 insulating fibers 121 having substantially the same diameter, and gaps are formed between the adjacent insulating fibers 121. Similarly, each of the weft yarns 13 is formed by bundling about 10 to 200 insulating fibers 131 having substantially the same diameter, and gaps are formed between the adjacent insulating fibers 131. The insulating fibers 121 and 131 in the embodiment are all configured with glass fibers and have substantially the same diameter of about 1 to 20 µm.

The insulating fibers 121 and 131 are not particularly limited to the above-mentioned glass fibers as long as the insulating fibers have electrical insulation properties, heat resistance, and flexibility. For example, the insulating fibers 121 and 131 may be configured with resin fibers such as nylon fiber, rayon fiber, polyester fiber, polyamide fiber, vinyl fiber, or aramid fiber. In order to improve performance such as adhesion strength with the conductive body 20, strength of the support body 10, affinity with the metal oxide ink and the conductive ink (which will be described later), chemical treatment or physical treatment may be applied on the surface of the insulating fibers 121 and 131.

Each of the warp yarns 12 may be configured with the same type of insulating fibers or may be configured with plural types of insulating fibers. Similarly, each of weft yarns 13 may be configured with the same type of insulating fiber or may be configured with plural types of insulating fibers. For example, although not particularly illustrated, a single weaving yarn may be formed by using both glass fiber and resin fiber. Herein, as an element for making the type of insulating fiber different, for example, the material constituting the insulating fiber, the diameter of the insulating fiber, and the like may be exemplified.

The warp yarns 12 and the weft yarns 13 may be configured with the same type of weaving yarns or may be configured with different types of weaving yarns. Herein, as an element for making the type of the weaving yarn different, for example, the material of the insulating fiber, the diameter of the insulating fiber, the number of insulating fibers constituting the weaving yarn, the density of the insulating fibers constituting the weaving yarn, and the like may be exemplified.

The method of weaving the woven fabric is not particularly limited to the above-mentioned plain weave as long as the woven fabric is woven by regularly weaving the weaving yarns. For example, a woven fabric woven by weaving with twill weave, satin weave, or the like may be used as the support body 10.

The intersection angle between the warp yarn 12 and the weft yarn 13 is not particularly limited to the above-mentioned right angle. As long as the warp yarns 12 and the weft yarns 13 intersect each other, and the intersection angle between the warp yarns 12 and the weft yarns 13 can be arbitrarily set.

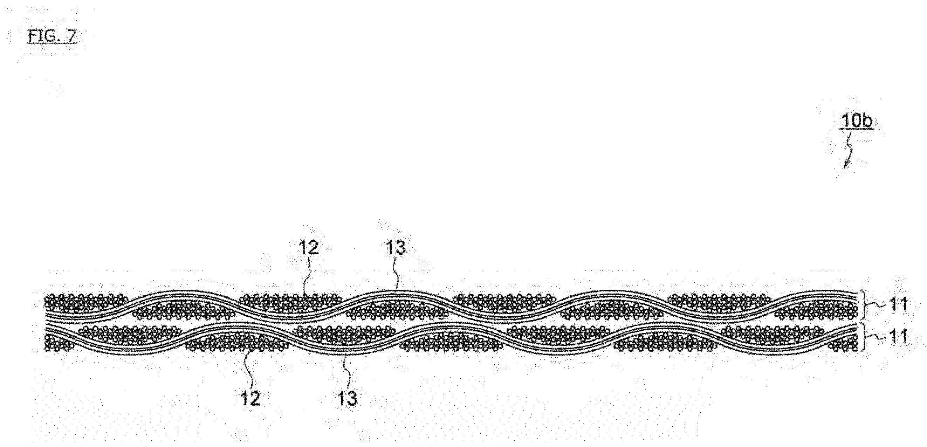

Furthermore, the number of the woven fabrics constituting the support body 10 is also not particularly limited, and the support body may be configured by stacking a plurality of woven fabrics on each other. Fig. 7 is a cross-sectional view illustrating a modified example of the support body in the first embodiment of the invention.

For example, as illustrated in Fig. 7, the support body 10b may be configured by stacking two sheets of the woven fabric 11 on each other. After uniformly and partially coating a tackifier (or an adhesive) having electrical insulation properties on the surface of one of the woven fabrics 11, by stacking the other woven fabric 11 on the woven fabric 11, the support body 10b may be formed. A plurality of the woven fabrics 11 may be configured with the same type of woven fabric or may be configured with plural types of woven fabrics. Herein, as an element for making the type of the woven fabric different, for example, the material constituting the insulating fiber, the diameter of the insulating fiber, the number of the insulating fibers constituting the weaving yarn, the density of the insulating fibers constituting the weaving yarn, the method of weaving the woven fabric, the thickness of the woven fabric, and the like may be exemplified.

As illustrated in Figs. 1 to 3, the conductive body 20 includes a first conductive path 21 provided on an upper face 101 of the support body 10 and a second conductive path 22 provided on a lower face 102 of the support body 10.

The first conductive path 21 extends in a planar direction of the upper face 101 of the support body 10 and forms a wiring portion 201 and a pair of land portions 202 and 203. On the upper face 101 of the support body 10, the pair of land portions 202 and 203 are provided at the ends of the wiring portion 201, respectively, and are connected to each other via the wiring portion 201.

Similarly, the second conductive path 22 also extends in a planar direction of the lower face 102 of the support body 10 and forms a wiring portion 204 and a pair of land portions 205 and 206. Also on the lower face 102 of the support body 10, the pair of land portions 205 and 206 are provided at the ends of the wiring portion 204, respectively, and are connected to each other via the wiring portion 204.

In the embodiment, the planar shape of the first conductive path 21 and the planar shape of the second conductive path 22 are substantially the same. Then, in a see-through (transparent) plan view (in a plan view when the wiring board 1 is transparently viewed from the upper or lower side (normal direction of the wiring board 1)), the entire first conductive path 21 and the entire second conductive path 22 overlap each other.

The planar shape of the first conductive path 21 is not limited to the shape having the wiring portion 201 and the pair of land portions 202 and 203 as described above, and an arbitrary planar shape can be adopted. Similarly, the planar shape of the second conductive path 22 is not limited to a shape having the wiring portion 204 and the pair of land portions 205 and 206 as described above, and an arbitrary planar shape can be adopted.

As described later, in a case where the planar shape of the first conductive path 21 and the planar shape of the second conductive path 22 are substantially the same, the first conductive path 21 and the second conductive path 22 may partially overlap each other in a see-through plan view. Alternatively, in a case where the planar shape of the first conductive path 21 and the planar shape of the second conductive path 22 are substantially the same, the first conductive path 21 and the second conductive path 22 may not necessarily overlap in the see-through plan view.

Even in a case where the planar shape of the first conductive path 21 and the planar shape of the second conductive path 22 are different, the first conductive path 21 and the second conductive path 22 may partially overlap each other in a transmission plan view. Alternatively, in a case where the planar shape of the first conductive path 21 and the planar shape of the second conductive path 22 are different, the first conductive path 21 and the second conductive path 22 may not necessarily overlap in the transmission plan view.

The conductive body 20 is made of a metallic material such as copper (Cu), silver (Ag), or iron (Fe) and has conductivity. The conductive body 20 may contain plural types of metallic materials. As described later, the conductive body 20 is formed by photosintering after drying the metal oxide ink coated and impregnated on the support body 10. For this reason, in the embodiment, as illustrated in Fig. 3, the first conductive path 21 has a first conductor portion 211 and a first intervening portion 212.

The first conductor portion 211 and the first intervening portion 212 are formed integrally with the first conductive path 21. The first conductor portion 211 exists in the basket hole 14 (that is, the opening between the weaving yarns 12 and 13) of the woven fabric 11 constituting the support body 10. The first intervening portion 212 enters the gap formed between the insulating fibers 121 and 131 and exists in the gap.

Similarly, the second conductive path 22 also has the second conductor portion 221 and the second intervening portion 222. The second conductor portion 221 and the second intervening portion 222 are integrally formed with the second conductive path 22. The second conductor portion 221 exists in the basket hole 14 (that is, the opening between the weaving yarns 12 and 13) of the woven fabric 11 constituting the support body 10. The second intervening portion 222 enters the gap formed between the insulating fibers 121 and 131 and exists in the gap.

Furthermore, in the embodiment, the first conductor portion 211 and the second conductor portion 221 are integrally formed. For this reason, the first conductive path 21 and the second conductive path 22 are electrically connected to each other via the first and second conductor portions 211 and 221. That is, the first and second conductor portions 211 and 221 function as an interlayer connection portion between the first conductive path 21 and the second conductive path 22.

Unsintered metal oxide may remain in a portion of the first intervening portion 212. Similarly, unsintered metal oxide may remain in a portion of the second intervening portion 222. As a specific example of the metal oxides, a copper oxide (Cu₂O, CuO), a silver oxide (Ag₂O), an iron oxide (FeO, Fe₂O₃), or the like may be exemplified.

The composition of the conductive body 20 is not particularly limited to the above-described configuration. For example, the conductive body 20 may be made of conductive metal particles containing copper (Cu) or silver (Ag) or the like as a main component and a binder resin. As described below, the conductive body 20 can be formed by heating and firing the conductive ink coated and impregnated on the support body 10. In this case, the first conductor portion 211 and the second conductor portion 221 are bonded to each other. The conductive body 20 may contain plural types of conductive metal particles.

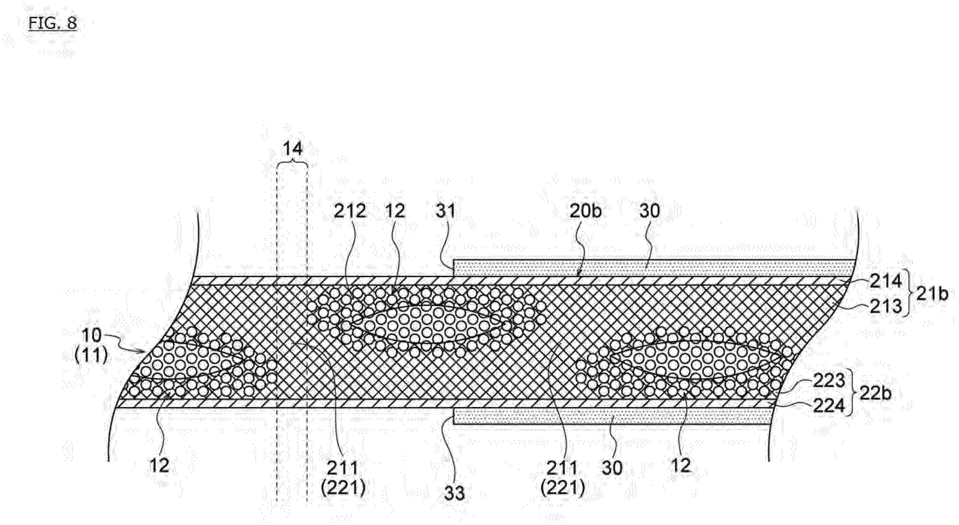

As illustrated in Fig. 8, the first conductive path 21b may include a plurality of conductive layers 213 and 214. Similarly, as illustrated in Fig. 8, the second conductive path 22b may include a plurality of conductive layers 223 and 224. Fig. 8 is a cross-sectional view illustrating a modified example of the wiring board in the first embodiment of the invention.

The additional conductive layers 214 and 224 are formed by coating the metal oxide ink or the conductive ink on the support body 10 plural times. Alternatively, additional conductive layers 214 and 224 may be formed by electrolytic plating treatment or electroless plating treatment. The number of the additional conductive layers 214 and 224 is not particularly limited, and a plurality of the conductive layers 214 and 224 may be formed.

By forming the additional conductive layers 214 and 224 by plating treatment, it is possible to increase the film thickness of the first and second conductive paths 21b and 22b, and it is possible to improve the surface smoothness (supplementation of surface irregularities and minute cracks and the like) of the first and second conductive paths 21b and 22b.

The first insulating layer 30 is made of, for example, a resin material, and has electrical characteristics including electrical insulation properties and mechanical properties such as flexibility and rigidity. As described later, the first insulating layer 30 is formed by impregnating the support body 10 on which the conductive body 20 is formed with the liquid resin and performing curing. For this reason, as illustrated in Figs. 1 to 3, the first insulating layer 30 covers the conductive body 20 and exists in the support body 10. In the embodiment, due to the first insulating layer 30, in addition to ensuring the mechanical strength of the wiring board 1, the protection of the conductive body 20, the electrical insulation property of the conductive body 20, and the electrical characteristics (dielectric constant and the like) of the conductive body 20, it is also possible to impart the above-mentioned peculiar texture, an arbitrary color, arbitrary flexibility, and the like to the wiring board 1.

First and second window portions 31 and 32 are formed on the upper face of the first insulating layer 30, and third and fourth window portions 33 and 34 are formed on the lower face of the first insulating layer 30. The first and second window portions 31 and 32 expose the land portions 202 and 203 of the first conductive path 21 toward the upper side, respectively. On the other hand, the third and fourth window portions 33 and 34 expose the land portions 205 and 206 of the second conductive path 22 toward the lower side, respectively. For this reason, it is possible to electrically connect to the conductive body 20 of the wiring board 1 from both upper and lower sides.

As described above, in the embodiment, since the support body 10 is configured with a woven fabric, it is possible to ensure excellent followability to the three-dimensional deformation due to the flexibility of the woven fabric in the portion of the support body 10 where the first and second conductive paths 21 and 22 do not exist.

On the other hand, in the embodiment, the first conductor portion 211 of the first conductive path 21 exists in the basket hole 14 of the woven fabric 11, and the first intervening portion 212 of the first conductive path 21 exists in the gap between the insulating fibers 131 and 141. In this manner, in the embodiment, since the first conductor portion 211 and the first intervening portion 212 are ingrown into the woven fabric 11, the adhesion strength (the bonding strength or the peeling strength) between the support body 10 and the first conductive path 21 can be improved due to the anchor effect. For this reason, even when the electronic component is mounted on the wiring board 1, it is possible to suppress the occurrence of the phenomenon that the first conductive path 21 is peeled off from the support body 10.

Similarly, the second conductor portion 221 of the second conductive path 22 exists in the basket hole 14 of the woven fabric 11, and the second intervening portion 222 of the second conductive path 22 exists in the gap between the insulating fiber 131 and 141. In this manner, in the embodiment, since the second conductor portion 221 and the second intervening portion 222 are ingrown into the woven fabric 11, the adhesion strength (the bonding strength or the peeling strength) between the support body 10 and the second conductive path 22 can be improved due to the anchor effect. For this reason, even when the electronic component is mounted on the wiring board 1, it is possible to suppress the occurrence of the phenomenon that the second conductive path 22 is peeled off from the support body 10.

In some cases, when a wiring board is manufactured by a photosintering process, unreduced/unsintered metal oxide may remain as an insulator on the bottom of the conductive thin film. For this reason, it is difficult to form a wiring board having a so-called double-sided wiring structure (a structure in which wirings are provided on both faces of the board) or a double-sided exposure structure (a structure in which electrical connection from the other face to a conductive thin film formed on one face of the board is possible; a double access structure).

In contrast, in the embodiment, the first conductive path 21 and the second conductive path 22 are electrically connected to each other via the first and second conductor portions 211 and 221. In addition, the basket holes 14 formed with the first and second conductor portions 211 and 221 are regularly and uniformly arranged in the woven fabric 11. For this reason, even in a case where a photosintering process is used, it is possible to form the wiring board 1 having the same function as the wiring board having the double-sided wiring structure or the double-sided exposure structure.

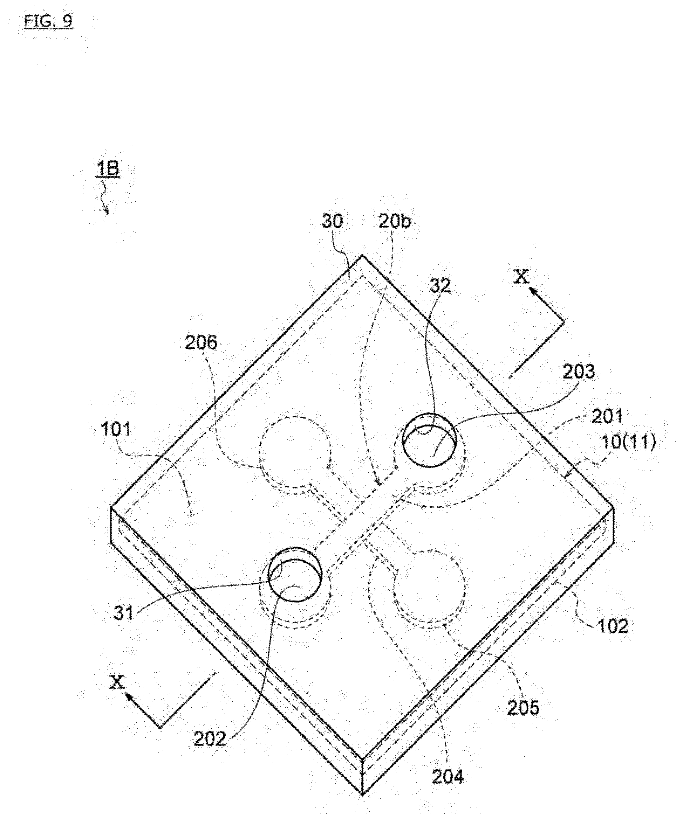

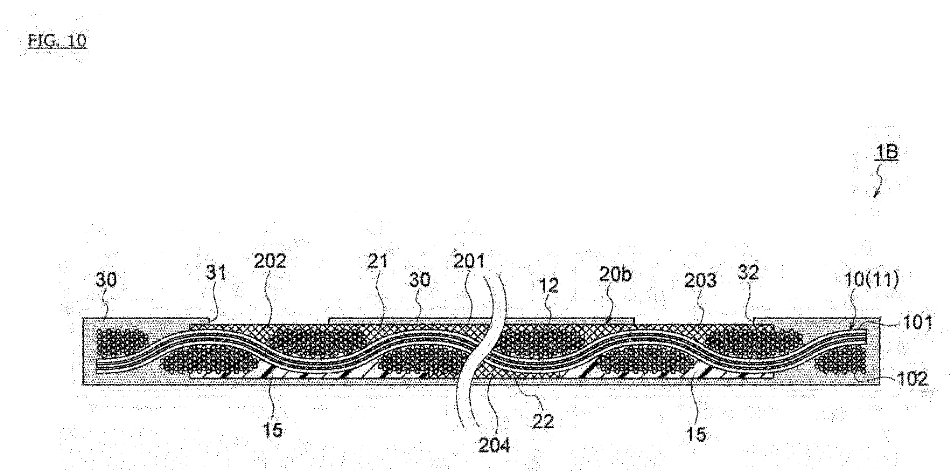

Fig. 9 is a cross-sectional view illustrating a wiring board in a second embodiment of the invention, and Fig. 10 is a cross-sectional view taken along line X-X of Fig. 9.

As illustrated in Figs. 9 and 10, the first conductive path 21 and the second conductive path 22 may partially overlap each other. That is, in a conductive body 20b of a wiring board 1B in the second embodiment of the invention, the planar shape of the first conductive path 21 and the planar shape of the second conductive path 22 are substantially the same, but in comparison with the shape illustrated in Fig. 1, in a see-through plane view, the second conductive path 22 is substantially perpendicular to the first conductive path 21, and the first conductive path 21 and the second conductive path 22 overlap each other only at the central portions of the first and second conductive paths 21 and 22. As a result, in the embodiment, the first and second conductor portions (not illustrated in Figs. 9 and 10 and corresponding to the reference numerals 211 and 221 illustrated in Fig. 3) are integrally formed only at the central portions of the first and second conductive paths 21 and 22, and the first conductive path 21 and the second conductive path 22 are electrically connected via the first and second conductor portions only at the central portions of the first and second conductive paths 21 and 22.

In this case, as illustrated in Fig. 10, the second resin layer 15 may be provided in the region of the lower face 102 of the support body 10 corresponding to the first conductive path 21. The second resin layer 15 has electrical insulation properties, and before coating the metal oxide ink or the conductive ink on the support body 10, the second resin layer is formed on the lower face 102 of the support body 10 in advance, except for the portion where the formation of the second conductive path 22 is planned. The basket hole 14 of the woven fabric 11 is closed by the second resin layer 15. For this reason, it is possible to prevent the metal oxide ink or the conductive ink from permeating into the lower face 102 of the support body 10. The second resin layer 15 in the modified example illustrated in Fig. 10 corresponds to an example of the second insulating layer in the invention. It is not necessary to form the second resin layer 15 on the support body 10.

Although not particularly illustrated, the second resin layer 15 may be formed on the upper face 101 of the support body 10 in advance, except for the portion where the formation of the first conductive path 21 is planned.

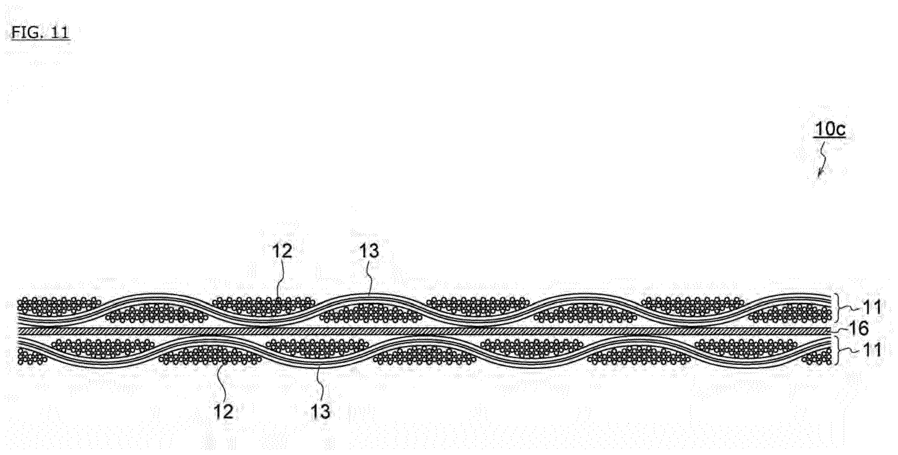

Instead of the second resin layer 15, as illustrated in Fig. 11, the support body 10c may have the insulating sheet 16. Fig. 11 is a cross-sectional view illustrating a modified example of the support body in the second embodiment of the invention.

In the example illustrated in Fig. 11, the support body 10c has two woven fabrics 11 and an insulating sheet 16 interposed between the woven fabrics 11. This insulating sheet 16 has electrical insulation properties and has a tacky layer or an adhesive layer on both sides of the insulating sheet. By the insulating sheet 16, two sheets of woven fabric 11 are adhered together, and the basket hole 14 of the woven fabric 11 is closed. For this reason, it is possible to prevent the metal oxide ink coated on one face of the support body 10c from permeating into the other surface of the support body 10c. The insulating sheet 16 in the modified example illustrated in Fig. 11 corresponds to an example of the third insulating layer in the invention. In the example illustrated in Fig. 11, the insulating sheet 16 is provided over the entire area of the support body 10c, but the insulating sheet 16 may be partially provided on the support body 10c.

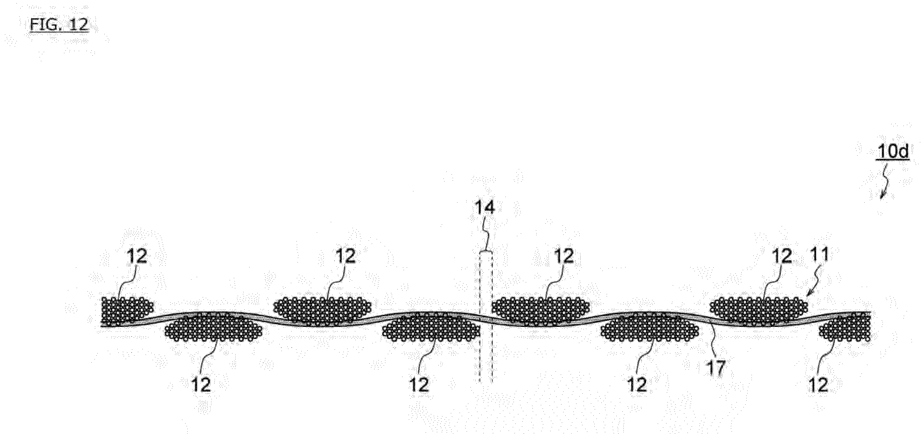

Alternatively, instead of the second resin layer 15, as illustrated in Fig. 12, the support body 10d may have the third resin layer 17. Fig. 12 is a cross-sectional view illustrating another modified example of the support body in the second embodiment of the invention. Fig. 12 illustrates a cross-sectional view in a case where the support body 10d is cut at the same position as that in Fig. 6 for the better understanding of the structure of the third resin layer 17 particularly at the basket hole 14.

In the example illustrated in Fig. 12, the support body 10d has a third resin layer 17 provided so as to extend to the center of the woven fabric 11 in addition to the woven fabric 11. The third resin layer 17 has electrical insulation properties, and before coating the metal oxide ink or the conductive ink on the woven fabric 11, the third resin layer is formed by curing a liquid resin having a relatively low viscosity in a state of staying in the center of the woven fabric 11. The basket hole 14 of the woven fabric 11 is closed by the third resin layer 17. For this reason, it is possible to prevent the metal oxide ink or the conductive ink coated on one face of the support body 10d from permeating into the other face of the support body 10d. The third resin layer 17 in the modified example illustrated in Fig. 12 corresponds to an example of the third insulating layer in the invention. In the example illustrated in Fig. 12, the third resin layer 17 is provided over the entire area of the support body 10d, but the third resin layer 17 may be partially provided on the support body 10d.

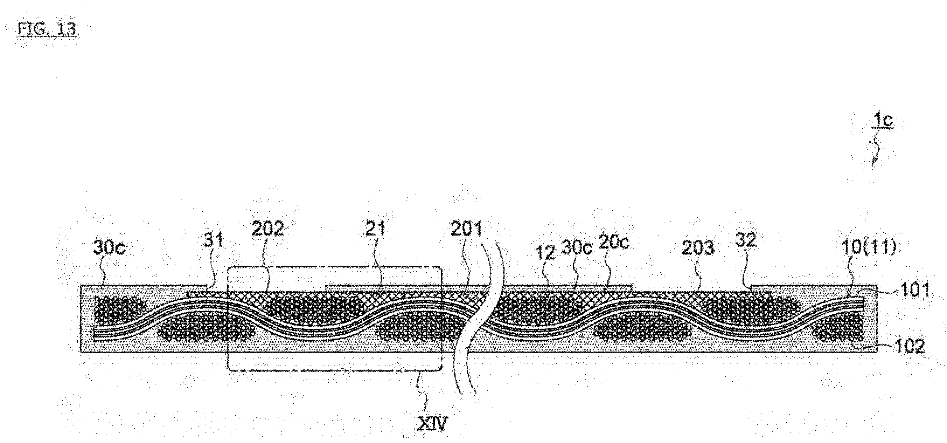

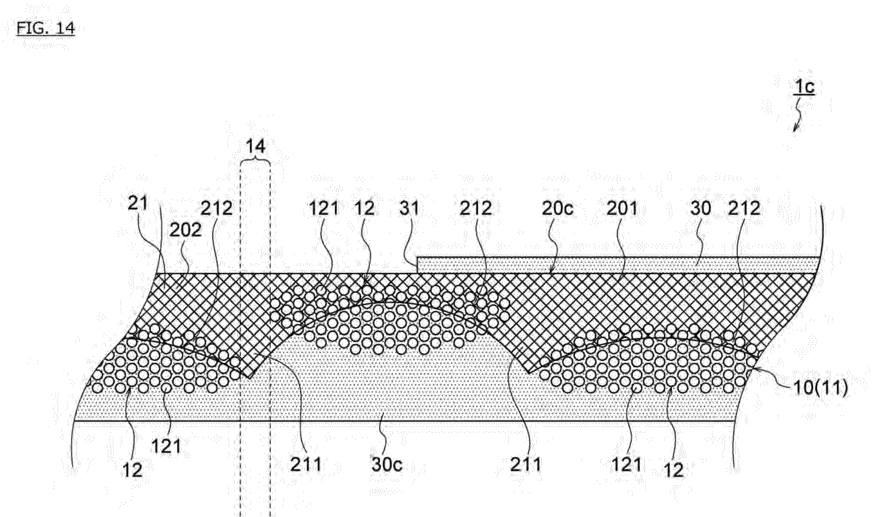

Fig. 13 is a cross-sectional view illustrating a wiring board in a third embodiment of the invention, and Fig. 14 is a cross-sectional view of a portion XIV of Fig. Fig. 14 is not an exact enlarged view of the portion XIV of Fig. 13, but Fig. 14 illustrates a cross-sectional view in a case where a cross section of Fig. 13 is parallel-translated to the basket hole 14, as in the above-described Fig. 3, for the better understanding of the structure of the first conductor portion 211 of the first conductive path 21.

Although the wiring boards 1 and 1B in the above-described first and second embodiments have a double-sided wiring structure, as illustrated in Figs. 13 and 14, the wiring board 1C may have a single-sided wiring structure (a structure in which wiring is provided on only one face). That is, the conductive body 20c of the wiring board 1C in the third embodiment of the invention includes only the first conductive path 21 provided on the upper face 101 of the support body 10. As described above, the first conductive path 21 has the first conductor portion 211 and the first intervening portion 212. The first conductor portion 211 exists in the basket hole 14 (that is, the opening between the weaving yarns 12 and 13) of the woven fabric 11 constituting the support body 10. On the other hand, the first intervening portion 212 enters the gap formed between the insulating fibers 121 and 131 and exists in the gap.

As compared with the first insulating layer 30 described above, in the first insulating layer 30c of the wiring board 1C, only the first and second window portions 31 and 32 formed on the upper face of the first insulating layer 30c are formed, and instead of the second conductive path 22, the first insulating layer 30c exists on the lower face 102 of the support body 10.

Also in the wiring board 1C having the single-sided wiring structure illustrated in Figs. 13 and 14, since the support body 10 is configured with a woven fabric, it is possible to ensure excellent followability to the three-dimensional deformation due to the flexibility of the woven fabric 11 in the portion of the support body 10 where the first conductive path 21 does not exist.

In the embodiment, similarly to the above-described embodiment, since the first conductor portion 211 and the first intervening portion 212 are ingrown into the woven fabric 11, the adhesion strength (the bonding strength or the peeling strength) between the support body 10 and the first conductive path 21 can be improved due to the anchor effect. For this reason, even when the electronic component is mounted on the wiring board 1, it is possible to suppress the occurrence of the phenomenon that the first conductive path 21 is peeled off from the support body 10.

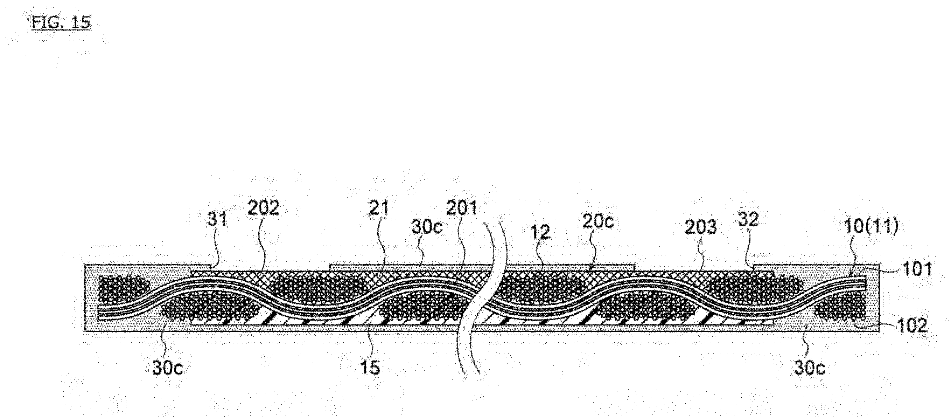

In the third embodiment of the invention, as illustrated in Fig. 15, the second resin layer 15 may be provided in the region of the lower face 102 of the support body 10 corresponding to at least a portion of the first conductive path 21. Fig. 15 is a cross-sectional view illustrating a modified example of the wiring board in the third embodiment of the invention.

The second resin layer 15 has electrical insulation properties and is formed in advance on the lower face 102 of the support body 10 before coating the metal oxide ink or the conductive ink on the support body 10. The basket hole 14 of the woven fabric 11 is closed by the second resin layer 15. For this reason, it is possible to prevent the metal oxide ink from permeating into the lower face of the support body 10. In addition, by forming the second resin layer 15 on the wiring board, the rigidity of the wiring board can be partially reinforced, and thus, for example, when the electronic component is mounted on the wiring board, it is possible to suppress deformation of the wiring board. The second resin layer 15 in the modified example illustrated in Fig. 15 corresponds to an example of the second insulating layer in the invention.

In the modified example illustrated in Fig. 15, the second resin layer 15 may be formed partially only around the basket hole 14 of the woven fabric 11.

Although not particularly illustrated, a wiring board having a single-sided wiring structure may be configured by using the support body 10c illustrated in Fig. 11 or the support body 10d illustrated in Fig. 12 instead of the support body 10 having the second resin layer 15.

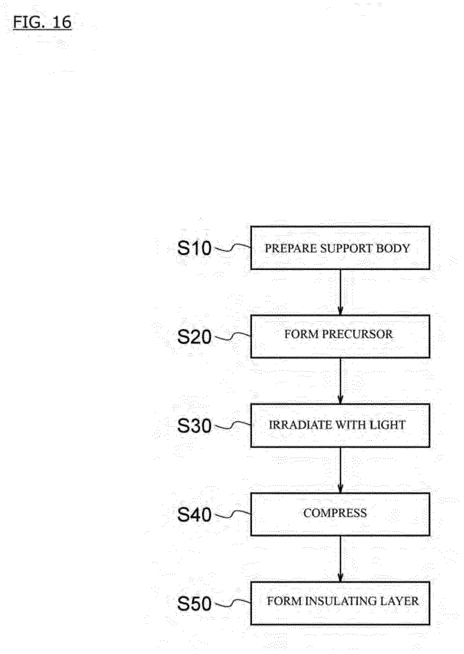

Hereinafter, a method of manufacturing the wiring board 1 having the double-sided wiring structure in the first embodiment of the invention will be described with reference to Figs. 16 to 20(b).

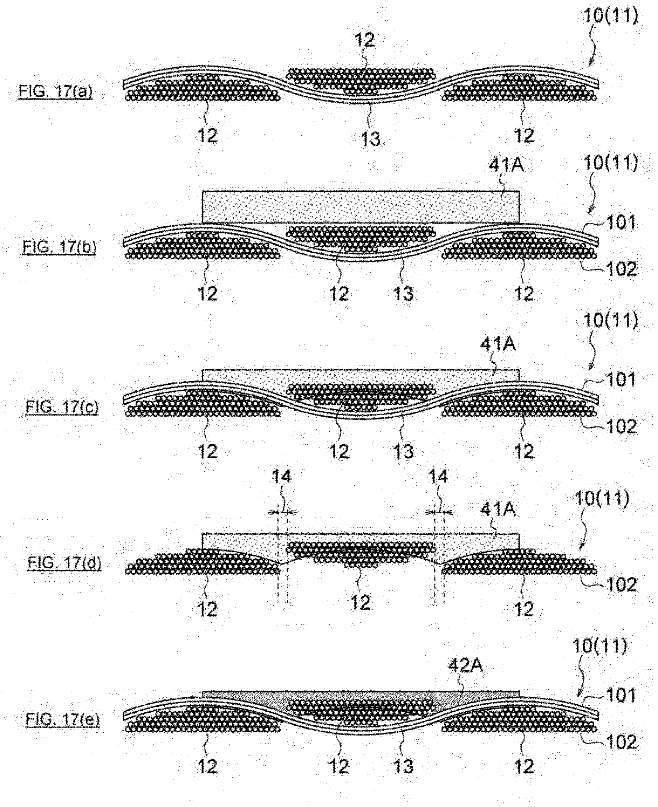

Fig. 16 is a process chart illustrating a method of manufacturing a wiring board in the first embodiment of the invention, and Figs. 17(a) to 20(b) are diagrams illustrating steps of Fig. 16. In Figs. 16 to 20(b), the method of manufacturing the wiring board 1 by a photosintering process by using a metal oxide ink will be described.

First, in step S10 of Fig. 16, the support body 10 is prepared as illustrated in Fig. 17(a). Although not particularly limited, as a specific example of the support body 10, those having the following specifications may be exemplified.

That is, the insulating fibers 121 of the warp yarn 12 are configured with glass fibers having a diameter of about 7 µm, and each warp yarn 12 is configured by bundling about 200 insulating fibers 121. The insulating fiber 131 of the weft yarn 13 is also configured with glass fibers having a diameter of about 7 µm, and each weft yarn 13 is configured by bundling about 200 insulating fibers 131. A woven fabric (glass cloth) 11 having a thickness of about 0.1 mm is woven from the weaving yarns 12 and 13, and the support body 10 is configured by a single sheet of the woven fabric 11. In the woven fabric 11, the weaving yarns 12 and 13 are woven with plain weave so that the density of the warp yarns 12 is about 60 per 25 mm in the lateral direction and the density of the weft yarns 13 is about 60 per 25 mm in the lateral direction. A number of the basket holes 14 having a rectangular opening shape of about 20 µm × 20 µm exist at a pitch of about 0.3 mm in the woven fabric 11 of such specifications.

In a case where the support body 10 has the second resin layer 15 similarly to the wiring board 1B illustrated in Fig. 10, in step S10, the second resin layer 15 is formed by selectively coating a liquid resin on the lower face of the woven fabric 11 and performing curing.

In the case of using the support body 10c illustrated in Fig. 11, in step S10, the support body 10c is prepared by laminating two sheets of the woven fabric 11 via the insulating sheet 16.

In the case of using the support body 10d illustrated in Fig. 12, in step S10, the third resin layer 17 are formed by curing a liquid resin having a relatively low viscosity in a state of staying in the center of the woven fabric 11.

Subsequently, in step S20 of Fig. 16, metal oxide-containing portions 42A and 42B which are precursors of the conductive body 20 are formed (refer to Figs. 17(b) to 18(d)).

Specifically, in step S20, first, as illustrated in Fig. 17(b), the metal oxide ink 41A is coated on one main face 101 of the support body 10. The metal oxide ink 41A is coated on the support body 10 in a planar pattern corresponding to the planar shape of the first conductive path 21. The metal oxide ink 41A in the embodiment corresponds to an example of the dispersion liquid in the invention.

The metal oxide ink 41A is a solution containing metal oxide particles and a reducing agent. As a specific example of the metal oxide particles, nanoparticles of a copper oxide (Cu₂O), a silver oxide (Ag₂O), an iron oxide (FeO, Fe₂O₃), or the like may be exemplified. As a reducing agent, a material containing carbon atoms functioning as a reducing group at the time of the reduction reaction of the metal oxide may be used, and for example, a hydrocarbon compound such as ethylene glycol or formaldehyde may be exemplified. In addition, as a solvent contained in the solution of the metal oxide ink 41A, for example, water or various organic solvents may be used. The metal oxide ink 41A may contain a polymer compound as a binder component or various types of regulating agents such as a surfactant. In a case where the metal oxide particles are a silver oxide (Ag₂O), the dispersion liquid may not necessarily contain the reducing agent.

The metal oxide ink 41A may contain plural types of metal oxide particles. Metal nanoparticles of copper (Cu), silver (Ag), iron (Fe), platinum (Pt), gold (Au), or the like may be used in addition to the metal oxide particles. Alternatively, metal nanoparticles of copper (Cu), silver (Ag), iron (Fe), platinum (Pt), gold (Au), or the like may be used instead of the metal oxide particles. In this case, the dispersion liquid does not necessarily contain a reducing agent.

As the method of coating the metal oxide ink 41A on the support body 10 is not particularly limited, but either a contact coating method or a non-contact coating method may be used. As a specific example of the contact coating method, screen printing, gravure printing, offset printing, gravure offset printing, flexographic printing, or the like may be exemplified. On the other hand, as a specific example of the non-contact coating method, inkjet printing, spray coating, dispensing coating, jet dispensing, and the like may be exemplified.

The number of times of coating of the metal oxide ink 41A on the support body 10 is not particularly limited to one time, and the metal oxide ink 41 may be coated on one main face 101 of the support body 10 plural times. The components of the metal oxide ink 41A may be allowed to be different for each coating.

As illustrated in Fig. 17(c), a portion of the metal oxide ink 41A coated on one main face 101 of the support body 10 remains on one main face 101 of the support body 10 to form a surface layer. On the other hand, as illustrated in Fig. 17(d), the remaining portion of the metal oxide ink 41A permeates (infiltrates) into the support body 10 via the basket holes 14 of the woven fabric 11 and the gap between the insulating fibers 121 and 131 in a state where the planar pattern is maintained. The permeating metal oxide ink 41A is retained in the basket hole 14 of the woven fabric 11 and is retained in the gap between the insulating fibers 121 and 131 by the surface tension of the metal oxide ink 41A.

Next, as illustrated in Fig. 17(e), the metal oxide-containing portion 42A is formed by removing the solvent by drying the metal oxide ink 41A. Specifically, the metal oxide ink 41A is dried at 100 to 120°C for about 20 to 120 minutes by a drying apparatus. At this time, in the embodiment, since the metal oxide ink 41A retained in the basket holes 14 of the woven fabric 11 and the gap between the insulating fibers 121 and 131 is also dried, the metal oxide-containing portion 42A also exists in the basket holes 14 of the woven fabric 11 and the gap between the insulating fibers 121 and 131. The metal oxide-containing portion 42A before the photosintering mainly contains the above-mentioned metal oxide particles (copper oxide or the like). The metal oxide-containing portion 42A in the embodiment corresponds to an example of the precursor in the invention.

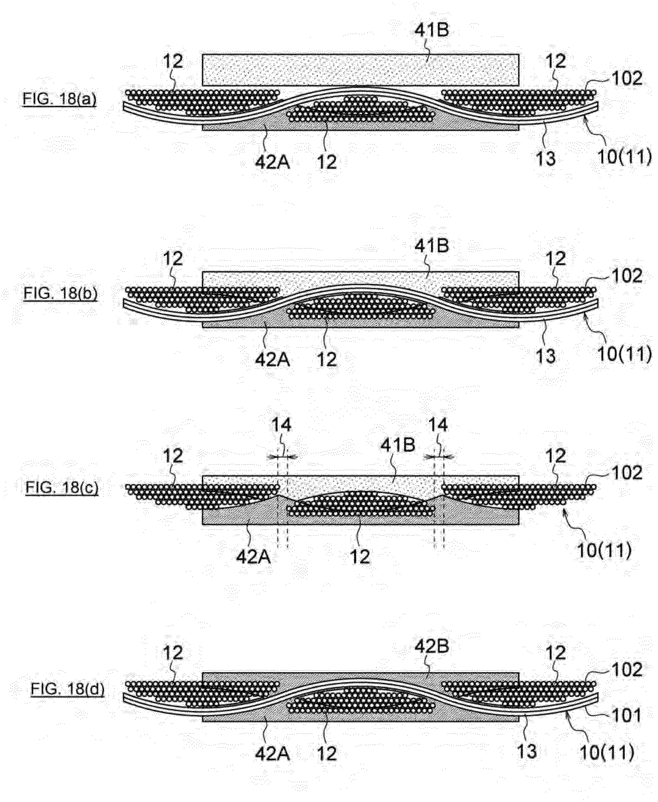

Then, as illustrated in Fig. 18(a), the metal oxide ink 41B is coated on the other main face 102 of the support body 10. The metal oxide ink 41B is coated on the support body 10 in a planar pattern corresponding to the planar shape of the second conductive path 22. In the embodiment, the metal oxide ink 41B is a solution having the same components as those of the metal oxide ink 41A, but as long as the metal oxide ink 41B is a solution containing the metal oxide particles and the reducing agent described above, a solution having components different from those of the metal oxide ink 41A may be used. The metal oxide ink 41B in the embodiment corresponds to an example of the dispersion liquid in the invention.

As illustrated in Fig. 18(b), a portion of the metal oxide ink 41B coated on the other main face 102 of the support body 10 remains on the other main face 102 of the support body 10 to form a surface layer. On the other hand, as illustrated in Fig. 18(c), the remaining portion of the metal oxide ink 41B permeates (infiltrates) into the support body 10 via the basket holes 14 of the woven fabric 11 and the gap between the insulating fibers 121 and 131 in a state where the planar pattern is maintained. At this time, in the basket hole 14 of the woven fabric 11, the metal oxide ink 41B permeating from the second main face 102 of the support body 10 reaches the metal oxide ink 41A permeating from the first main face 101 of the support body 10. The permeating metal oxide ink 41B is retained in the basket holes 14 of the woven fabric 11 and the gap between the insulating fibers 121 and 131 by the surface tension of the metal oxide ink 41B.

Next, as illustrated in Fig. 18(d), the metal oxide-containing portion 42B is formed by removing the solvent by drying the metal oxide ink 41B. Specifically, the metal oxide ink 41B is dried at 100 to 120°C for about 20 to 120 minutes by a drying apparatus. At this time, in the embodiment, since the metal oxide ink 41B existing in the basket holes 14 of the woven fabric 11 and the gap between the insulating fibers 121 and 131 is also dried, the metal oxide-containing portion 42B also exists in the basket holes 14 of the woven fabric 11 and the gap between the insulating fibers 121 and 131. The metal oxide-containing portion 42B before the photosintering mainly contains the above-mentioned metal oxide particles (copper oxide or the like). The metal oxide-containing portion 42B in the embodiment corresponds to an example of the precursor in the invention.

In the case of manufacturing the wiring board 1C having a single-sided wiring structure as illustrated in Figs. 13 and 14, the metal oxide ink 41A may be coated only on one main face 101 of the support body 10, and the processes illustrated in Figs. 18(a) to 18(d) are unnecessary.

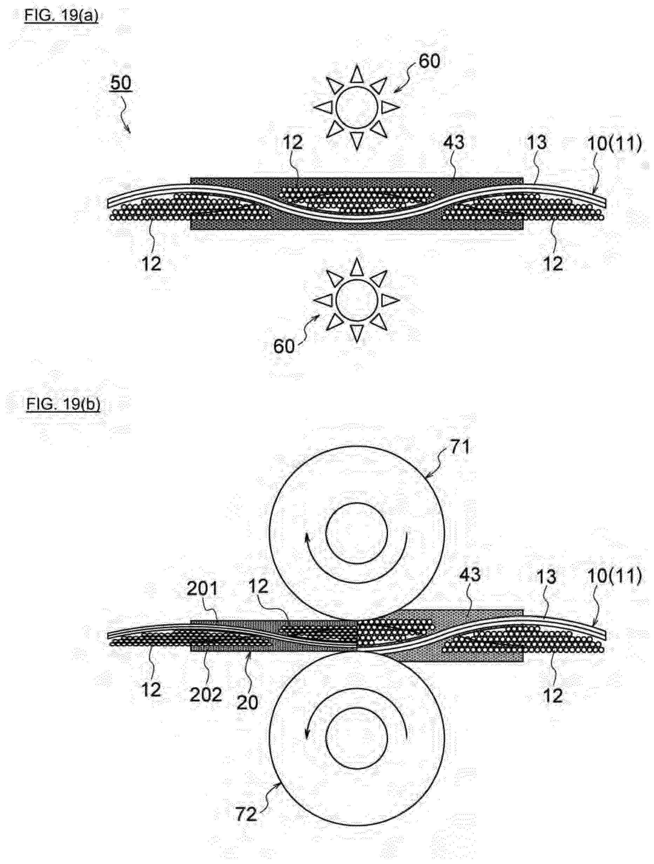

Then, in step S30 of Fig. 16, as illustrated in Fig. 19(a), pulsed light (pulsed electromagnetic wave) is output to the metal oxide-containing portions 42A and 42B of the support body 10 from the light sources 60 arranged on the upper and lower sides of the support body 10. Therefore, the reduction reaction of the metal oxide particles and the metal sintering are performed, so that the sintered body 43 is formed from the metal oxide-containing portions 42A and 42B. At this time, in the embodiment, the metal oxide-containing portions 42A and 42B existing in the basket hole 14 of the woven fabric 11 are integrated. In addition, the carbon dioxide (or oxygen gas) and vaporized gas of the solvent are released from the metal oxide-containing portions 42A and 42B in association with the reduction reaction, the sintered body 43 has a porous structure. The sintered body 43 is a layer containing a metal (copper or the like) obtained by reducing and sintering the metal oxide particles described above and has conductivity.

The light source 60 is not particularly limited, but a xenon lamp, a mercury lamp, a metal hydride lamp, a chemical lamp, a carbon arc lamp, an infrared lamp, a laser irradiation device, and the like may be exemplified. As the wavelength component included in the pulsed light irradiated from the light source, visible light, ultraviolet light, infrared light, and the like may be exemplified. The wavelength component included in the pulsed light is not particularly limited as long as the wavelength component is an electromagnetic wave, and for example, X-rays, microwaves, or the like may be included. The irradiation energy of the pulsed light irradiated from the light source 60 is, for example, about 6.0 to 9.0 J/cm², and the irradiation time of the pulsed light is about 2000 to 9000 µsec.

In a case where the additional conductive layers 214 and 224 illustrated in Fig. 8 are formed by plating treatment, the sintered body 43 is formed in step S30 and, after that, the plating treatment is applied to the sintered body 43, so that the additional conductive layers 214 and 224 are formed. Alternatively, after compressing the sintered body 43 in step S40 to be described later, the plating treatment may be applied to the compressed sintered body 43, so that the additional conductive layers 214 and 224 may be formed. As a specific example of the plating treatment, an electrolytic plating treatment or an electroless plating treatment may be exemplified.

Next, in step S40 of Fig. 16, as illustrated in Fig. 19(b), the intermediate body 50 (refer to Fig. 19(a)) having the sintered body 43 is passed between a pair of compression rollers 71 and 72. Each of the compression rollers 71 and 72 is a cylindrical roller configured with stainless steel or the like and has a smooth cylindrical pressing surface.

When the intermediate body 50 is passed between the compression rollers 71 and 72, the sintered body 43 is compressed in the thickness direction, and thus, the pores of the porous structure of the sintered body 43 are crushed. Therefore, the sintered metal agglomerates of the sintered body 43 are brought into close contact with each other, so that the conductive body 20 having a low surface resistance value is formed. For example, in a case where the surface resistance value of the sintered body 43 before compression is about 50 mΩ/m², the surface resistance value of the conductive body 20 becomes about 5 mΩ/m² through the compression step S40.

In addition, since the sintered body 43 is compressed, the contact density of the sintered metal agglomerates in the planar direction on the surfaces of the first and second conductive paths 21 and 22 which are in direct contact with the compression rollers 71 and 72 is greatly improved, and at the same time, glossiness is imparted to the surfaces of the first and second conductive paths 21 and 22. In the compression step S40, since the compression direction of the compression rollers 71 and 72 is the thickness direction of the support body 10, the pore between the insulating fibers 121 and 131 of the support body 10 is decreased in the thickness direction, but the opening area of the basket hole 14 penetrating in the thickness direction is not decreased.

In the embodiment, the sintered body 43 is compressed in step S40, so that the conductive body 20 is formed. As described above, the conductive body 20 includes the first conductive path 21, the first conductor portion 211, and the first intervening portion 212 and includes the second conductive path 22, the second conductor portion 221, and the second intervening portion 222. In this case, since the metal oxide-containing portions 42A and 42B existing in the basket hole 14 are integrated in the above-described step S30, the first conductor portion 211 and the second conductor portion 221 after photosintering are also integrated. As a result, the first conductive path 21 and the second conductive path 22 are electrically connected to each other via the first and second conductor portions 211 and 221.

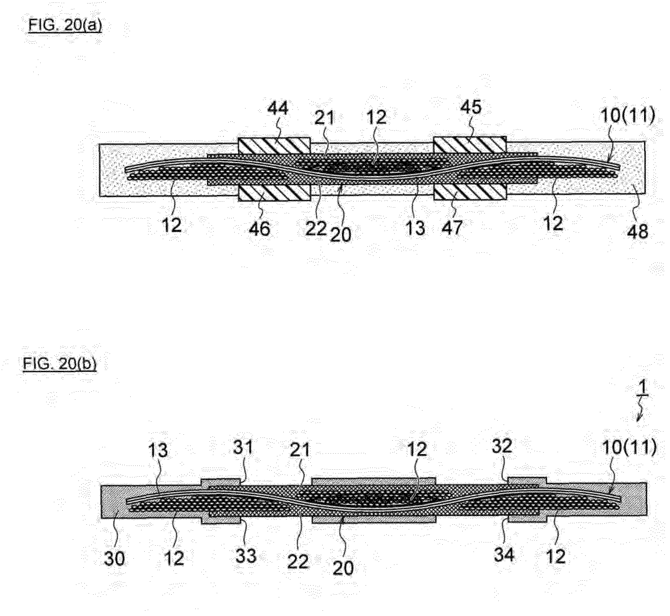

Next, in step S50 of Fig. 16, the first insulating layer 30 covering the support body 10 and the conductive body 20 is formed (refer to Figs. 20(a) and 20(b)).

Specifically, in step S50, as illustrated in Fig. 20(a), first, masks 44 and 45 are formed on the land portions 202 and 203 (refer to Figs. 1 and 2) of the upper side of the conductive body 20, and masks 46 and 47 are formed on the land portions 205 and 206 of the lower side of the conductive body 20 (refer to Figs. 1 and 2).

Next, as illustrated in Fig. 20(a), the liquid resin 48 is coated entirely on the support body 10 and the conductive body 20. Therefore, as illustrated in Fig. 20(a), the liquid resin 48 covers the surfaces of the first and second conductive paths 21 and 22 of the conductive body 20 and also permeates (infiltrates) the interior of the support body 10 via the basket holes 14 of the woven fabric 11 and the gap between the insulating fibers 121 and 131.

Although not particularly limited, as a specific example of the liquid resin 48, a polymer emulsion obtained by dispersing a copolymer in water may be exemplified. As a specific example of the copolymer, a copolymer obtained by copolymerizing acrylic acid ester or methacrylic acid ester as a main component and an appropriate amount of styrene or acrylonitrile for imparting necessary properties may be exemplified. As a method of coating the liquid resin, the above-mentioned contact coating method or non-contact coating method may be exemplified.

Next, as illustrated in Fig. 20(b), curing treatment is performed on the liquid resin 48 which covers the surface of the conductive body 20 and is impregnated in the support body 10 by heat treatment, ultraviolet irradiation treatment, or the like. After that, the first insulating layer 30 is formed by peeling off the masks 44 to 47 from the conductive body 20. In the curing treatment, additional treatment such as pressurization or depressurization may be performed at the same time.

In step S50 of Fig. 16, instead of the above-described liquid resin 48, by laminating a resin sheet in which openings corresponding to the window portions 31 to 34 are formed in advance on both sides of the support body 10 on which the conductive body 20 is formed and performing pressure and heat treatment, the first insulating layer 30 may be formed. Alternatively, instead of the above-described liquid resin 48, the first insulating layer 30 may be formed by an injection molding method using a mold for molding.

As described above, in the embodiment, the support body 10 is configured with the woven fabric 11, and in step S20 of Fig. 16, the metal oxide-containing portions 42A and 42B exist in the basket holes 14 and the gap between the insulating fibers 131 and 141. For this reason, while the adhesiveness between the support body 10 and the conductive body 20 is maintained by the conductor portions 211 and 221 or the intervening portions 212 and 222, it is possible to ensure excellent followability to the three-dimensional deformation due to the flexibility of the woven fabric 11 in the portion of the support body 10 where the first and second conductive paths 21 and 22 do not exist.

In the embodiment, in step S20 of Fig. 16, the metal oxide-containing portions 42A and 42B which are precursors of the conductive body 20 are formed so that the metal oxide-containing portions 42A and 42B exist in the basket holes 14 of the woven fabric 11 (that is, the gap between the weaving yarns 12 and 13) and exist in the gap between the insulating fibers 121 and 131. For this reason, since the first conductor portion 211 and the first intervening portion 212 after photosintering are ingrown into the woven fabric 11, the adhesion strength between the support body 10 and the first conductive path 21 can be improved due to the anchor effect.

Herein, for example, in the flexible printed wiring board (FPC) of the related art, since the conductive body is formed on the substrate, the material (polyimide or the like) constituting the substrate cannot be arbitrarily changed.

In contrast, in the embodiment, since the first insulating layer 30 is formed after the conductive body 20 is formed on the support body 10, it is possible to arbitrarily select the resin material constituting the first insulating layer 30 according to the use application of the wiring board 1. For this reason, it is possible to impart the above-mentioned peculiar texture to the wiring board 1, to impart an arbitrary color to the wiring board 1, or to impart flexibility superior to the FPC of the related art to the wiring board 1.

Furthermore, in the embodiment, in a state where the support body 10 on which the conductive body 20 is formed is deformed into a desired shape, the first insulating layer 30 can be formed by impregnating the support body 10 with a resin material and performing curing. For this reason, in the embodiment, the wiring board 1 may be used for applications requiring complicated or precise stereoscopic shapes.

Step S10 of Fig. 16 in the embodiment corresponds to an example of the first process in the invention, steps S20 to S40 of Fig. 16 in the embodiment correspond to an example of the second process in the invention, and step S50 of Fig. 16 in the embodiment corresponds to an example of the third process in the invention. Step S20 of Fig. 16 in the embodiment corresponds to an example of the first step in the invention, step S30 of Fig. 16 in the embodiment corresponds to an example of the second step in the invention, and step S40 of Fig. 16 in the embodiment corresponds to an example of the third step in the invention.

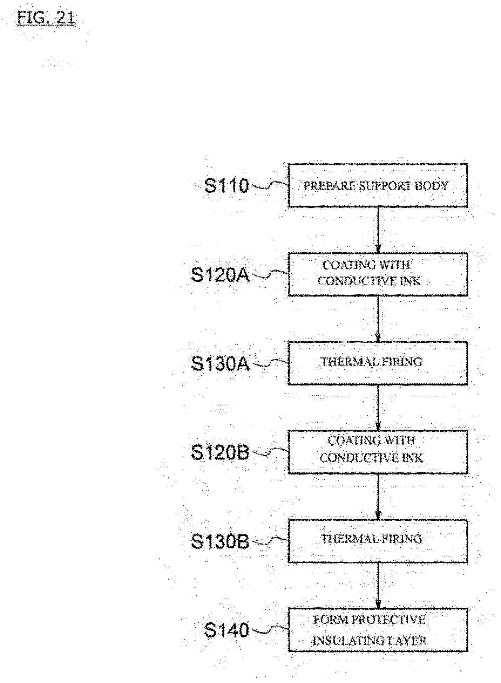

Instead of the photosintering process described above, the wiring board 1 can also be manufactured by using a conductive ink. Hereinafter, a method of manufacturing the wiring board 1 having a double-sided wiring structure in the first embodiment of the invention will be described with reference to Figs. 21 to 24(b).

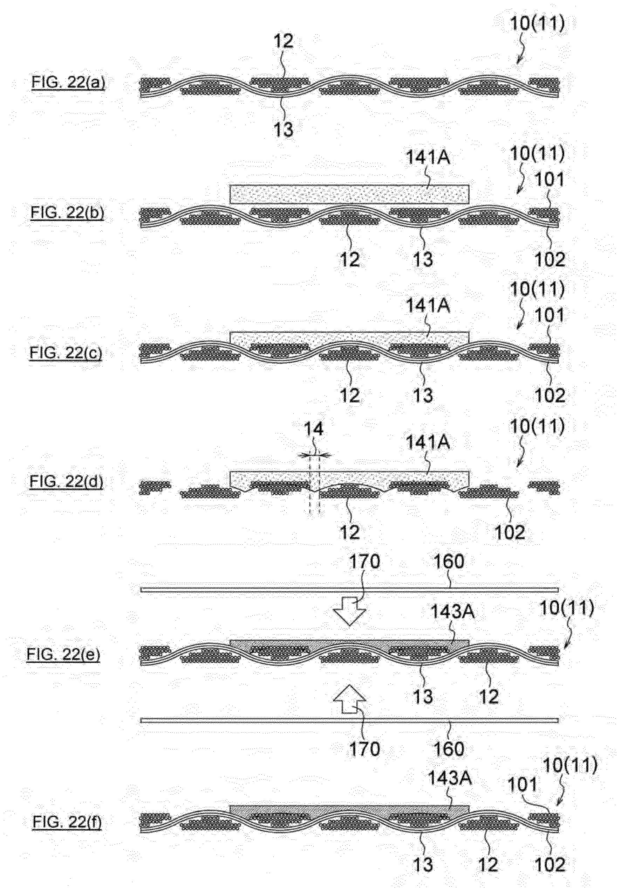

Fig. 21 is a process chart illustrating a method of manufacturing a wiring board in the first embodiment of the invention, and Figs. 22(a) to 24(b) are diagrams chart illustrating steps of Fig. 21. In Figs. 21 to 24(b), the method of manufacturing the wiring board 1 by using a conductive ink will be described.

First, in step S110 of Fig. 21, the support body 10 is prepared as illustrated in Fig. 22(a). Although not particularly limited, as a specific example of the support body 10, those having the above specifications may be exemplified.

Next, in step S120A of Fig. 21, as illustrated in Fig. 22(b), the conductive ink 141A is coated on one main face 101 of the support body 10. The conductive ink 141A is coated on the support body 10 in a planar pattern corresponding to the planar shape of the first conductive path 21.

The conductive ink 141A is a solution containing conductive metal particles and a binder resin that uniformly disperses the conductive metal particles. As a specific example of the conductive metal particles, for example, conductive metal particles containing copper (Cu) or silver (Ag) as a main component may be exemplified. As a binder resin, one or a mixed resin of two or more types of thermosetting resins such as a polyhydric phenol compound, a phenol resin, an alkyd resin, an unsaturated polyester resin, or an epoxy resin may be exemplified. At this time, an appropriate amount of an aqueous solvent or an organic solvent such as alcohols such as ethanol, methanol, or 2-propanol, isophorone, terpineol, triethylene glycol monobutyl ether, or butyl cellosolve acetate is mixed as a binder resin. The mixing amount of these solvent is appropriately adjusted according to the size and shape of the conductive metal particles, the film forming conditions, and the like.

As the method of coating the conductive ink 141A on the support body 10 is not particularly limited, but either a contact coating method or a non-contact coating method may be used. As a specific example of the contact coating method, screen printing, gravure printing, offset printing, gravure offset printing, flexographic printing, and the like may be exemplified. On the other hand, as a specific example of the non-contact coating method, inkjet printing, spray coating, dispensing coating, jet dispensing, and the like may be exemplified.

The number of times of coating of the conductive ink 141A on the support body 10 is not particularly limited to one time, and the conductive ink 141A may be coated on one main face 101 of the support body 10 plural times. The components of the conductive ink 141A may be different for each coating.

As illustrated in Fig. 22(c), a portion of the conductive ink 141A coated on one main face 101 of the support body 10 remains on one main face 101 of the support body 10 to form a surface layer. On the other hand, as illustrated in Fig. 22(d), the remaining portion of the conductive ink 141A permeates (infiltrates) into the support body 10 via the basket holes 14 of the woven fabric 11 and the gap between the insulating fibers 121 and 131, in a state where the planar pattern is maintained. The permeating conductive ink 141A is retained in the basket hole 14 of the woven fabric 11 and is retained in the gap between the insulating fibers 121 and 131 by the surface tension of the conductive ink 141A.

Next, in step S130A of Fig. 21, as illustrated in Figs. 22(e) and 22(f), the support body 10 and the conductive ink 141A are heated with heat energy 170 by the heat sources 160 arranged on the upper and lower sides of the support body 10. Therefore, in the conductive ink 141A, the metal bonding at the contact portion between adjacent metal particles and the thermal curing of the binder resin are performed, so that a fired body 143A having conductivity is formed. Due to the heating, the first conductor portion 211 is formed by curing the conductive ink 141A retained in the basket hole 14, and the first intervening portion 212 is formed by curing the conductive ink 141A retained in the gap between the insulating fibers 121 and 131.

The heat source 160 is not particularly limited, and an electric heating oven, an infrared oven, a far-infrared furnace (IR), a near-infrared furnace (NIR), a laser irradiation apparatus, and the like may be exemplified, and heat treatment combining these heat sources may be used. As a specific example, in a case where a far-infrared furnace is used, heat treatment is performed at about 150°C for about 10 minutes.

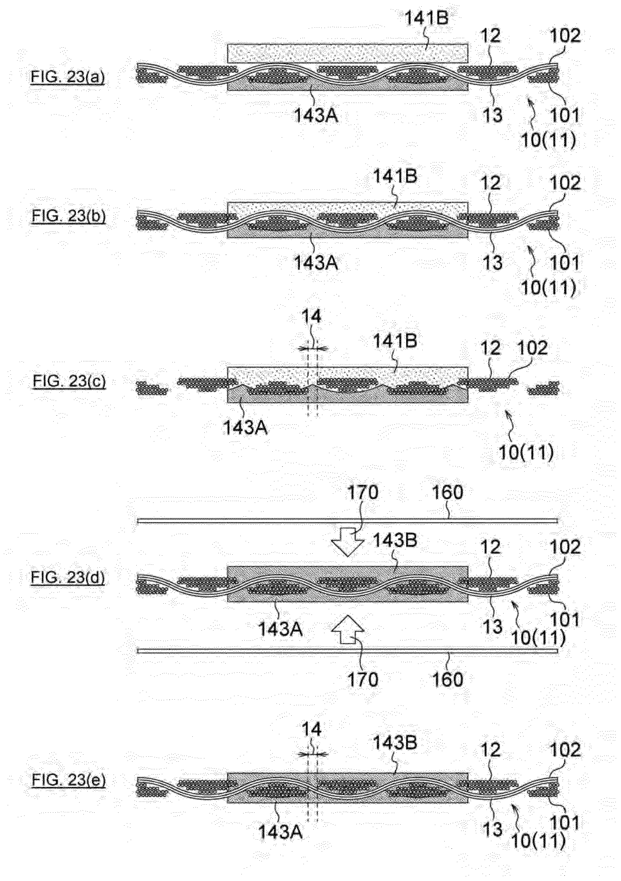

Next, in step S120B of Fig. 21, as illustrated in Fig. 23(a), the conductive ink 141B is coated on the other main face 102 of the support body 10. The conductive ink 141B is coated on the support body 10 in a planar pattern corresponding to the planar shape of the second conductive path 22. The conductive ink 141B is a conductive ink having the same composition as that of the conductive ink 141A, but a conductive ink having a composition different from that of the conductive ink 141A may be used. The method of coating the conductive ink 141B on the support body 10 is the same as the above-described coating method, but a coating method different from the above-described conductive ink 141A may be used.

As illustrated in Fig. 23(b), a portion of the conductive ink 141B coated on the other main face 102 of the support body 10 remains on the other main face 102 of the support body 10 to form a surface layer. On the other hand, as illustrated in Fig. 23(c), the remaining portion of the conductive ink 141B permeates (infiltrates) into the support body 10 via the basket hole 14 of the woven fabric 11 and the gap between the insulating fibers 121 and 131 in a state where the planar pattern is maintained. The permeating conductive ink 141B is retained in the basket hole 14 of the woven fabric 11 and is retained in the gap between the insulating fibers 121 and 131 by the surface tension of the conductive ink 141B.

Next, in step S130B of Fig. 21, as illustrated in Fig. 23(d), the conductive ink 141B of the support body 10 is heated by the heat sources 160 arranged on the upper and lower sides of the support body 10. Therefore, in the conductive ink 141B, the metal bonding at the contact portion between adjacent metal particles and the thermal curing of the binder resin are performed, so that a fired body 143B having conductivity is formed. Due to the heating, the second conductor portion 221 is formed by curing the conductive ink 141B retained in the basket hole 14, and the second intervening portion 222 is formed by curing the conductive ink 141B retained in the gap between the insulating fibers 121 and 131.

In addition, as illustrated in Fig. 23(e), the first and second conductor portions 211 and 221 retained in the basket hole 14 are bonded to each other due to heating in step S130B, and the first and second fired bodies 143A and 143B are electrically connected to each other via the first and second conductor portions 211 and 221. The first fired body 143A functions as the first conductor path 211 and the second fired body 143B functions as the second conductor path 221.

In the case of manufacturing the wiring board 1C having a single-sided wiring structure as illustrated in Figs. 13 and 14, the conductive ink 141A may be coated only on one main face 101 of the support body 10, and steps S120B and S130B in Fig. 21 of Fig. 21 are unnecessary.

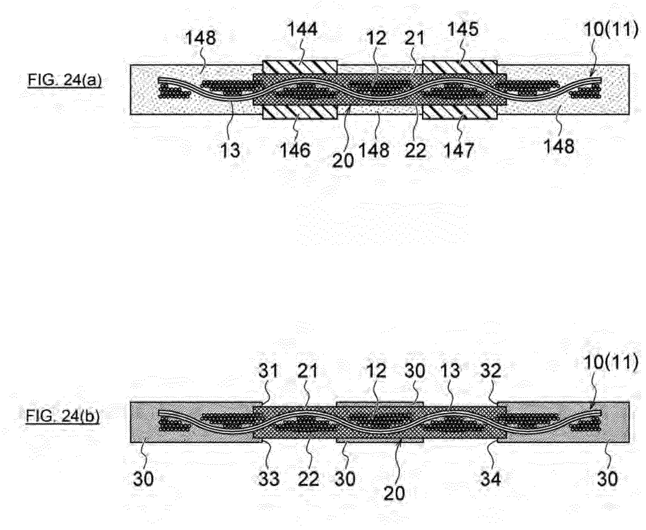

Next, in step S140 of Fig. 21, a first insulating layer 30 covering the support body 10 and the conductive body 20 is formed (refer to Figs. 24(a) and 24(b)).

Specifically, in step S140, as illustrated in Fig. 24(a), first, masks 144 and 145 are formed on the land portions 202 and 203 (refer to Figs. 1 and 2) of the upper side of the conductive body 20, and masks 146 and 147 are formed on the land portions 205 and 206 (refer to Figs. 1 and 2) of the lower side of the conductive body 20.

Next, as illustrated in Fig. 24(a), the liquid curable resin 148 is coated entirely on the support body 10 and the conductive body 20. Therefore, as illustrated in Fig. 24(a), the liquid curable resin 148 covers the surfaces of the first and second conductive paths 21 and 22 of the conductive body 20 and permeates (infiltrates) the interior of the support body 10 via the basket holes 14 of the woven fabric 11 and the gap between the insulating fibers 121 and 131. Although not particularly limited, as a specific example of the liquid curable resin 148, the liquid resin such as the above-described liquid resin 48 may be used.

Then, as illustrated in Fig. 24(b), curing treatment is performed on the liquid curable resin 148 which covers the surface of the conductive body 20 and is impregnated in the support body 10 by heat treatment, ultraviolet irradiation treatment, or the like. After that, the first insulating layer 30 is formed by peeling off the masks 144 to 147 from the conductive body 20. In the curing treatment, additional treatment such as pressurization or depressurization may be performed at the same time.

In step S140 of Fig. 21, instead of the liquid curable resin 148 in Figs. 24(a) and 24(b), the first insulating layer 30 may be formed by using a powder molding resin through an injection molding method using a molding die. Specifically, molding using a silicon rubber or the like may be exemplified.

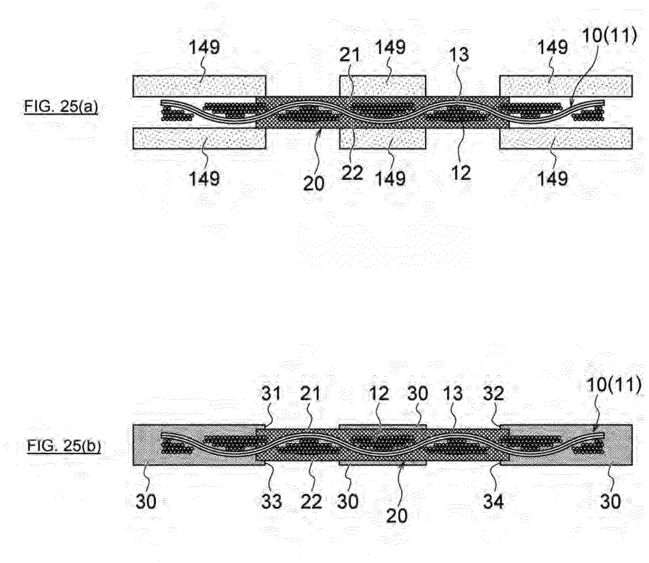

Alternatively, in step S140 of Fig. 21, instead of the liquid curable resin 148, as illustrated in Figs. 25(a) and 25(b), the first insulating layer 30 may be formed by using a curable resin sheet 149. Figs. 25(a) and 25(b) are cross-sectional views illustrating modified examples of step S140 of Fig. 21.

Specifically, as illustrated in Fig. 25(a), the curable resin sheet 149 having openings corresponding to the window portions 31 to 34 is prepared, and the resin sheet 149 is laminated on both faces of the support body 10 on which the conductive body 20 is formed. Although not particularly limited, as a specific example of the material constituting the curable resin sheet 149, for example, a synthetic rubber resin material which is a copolymer with 1,3-butadiene may be exemplified. As a specific example of the copolymer, a styrene rubber (SBR) which is a copolymer of styrene and 1,3-butadiene and a nitrile rubber (NBR) which is a copolymer of acrylonitrile and 1,3-butadiene may be exemplified. In step illustrated in Fig. 25(a), the curable resin sheet 149 covers the surfaces of the first and second conductive paths 21 and 22, but the curable resin sheet does not permeates (infiltrates) the interior of the support body 10.

Next, as illustrated in Fig. 25(b), the curable resin sheet 149 is pressurized and heated. At this time, the resin softened by heating permeates (infiltrates) the interior of the support body 10 via the basket holes 14 and the gap between the insulating fibers 121 and 131, and after that, the first insulating layer 30 is formed by curing the resin.

As described above, in the embodiment, the support body 10 is configured with the woven fabric 11, and in steps S120A to S130B of Fig. 21, the conductive inks 141A and 141B exist in the basket holes 14 and the gap between the insulating fibers 131 and 141. For this reason, while the adhesiveness between the support body 10 and the conductive body 20 is maintained by the conductor portions 211 and 221 or the intervening portions 212 and 222, it is possible to ensure excellent followability to the three-dimensional deformation due to the flexibility of the woven fabric 11 in the portion of the support body 10 where the first and second conductive paths 21 and 22 do not exist.

In the embodiment, in steps S120A to S130B in Fig. 21, the conductive inks 142A and 142B are coated so that the conductive inks 142A and 142B exist in the basket holes 14 of the woven fabric 11 (that is, in the openings between the weaving yarns 12 and 13) and exist in the gap between the insulating fibers 121 and 131. For this reason, since the first conductor portion 211 and the first intervening portion 212 after photosintering are ingrown into the woven fabric 11, the adhesion strength between the support body 10 and the first conductive path 21 can be improved by the anchor effect.

In the embodiment, since the first insulating layer 30 is formed after the conductive body 20 is formed on the support body 10, it is possible to arbitrarily select the resin material constituting the first insulating layer 30 according to the use application of the wiring board 1. For this reason, it is possible to impart the above-mentioned peculiar texture to the wiring board 1, to impart an arbitrary color to the wiring board 1, or to impart flexibility superior to the FPC of the related art to the wiring board 1.

Furthermore, in the embodiment, in a state where the support body 10 on which the conductive body 20 is formed is deformed into a desired shape, the first insulating layer 30 can be formed by impregnating the support body 10 with a resin material and performing curing. For this reason, in the embodiment, the wiring board 1 may be used for applications requiring complicated or precise stereoscopic shapes.

Step S110 of Fig. 21 in the embodiment corresponds to an example of the first process in the invention, steps S120A to S130B of Fig. 21 in the embodiment correspond to an example of the second process in the invention, and step S140 of Fig. 21 in the embodiment corresponds to an example of the third process in the invention. Steps S120A and 120B of Fig. 21 in the embodiment correspond to an example of the first step in the invention, and steps S130A and 130B of Fig. 21 in the embodiment correspond to an example of the second step in the invention.

The above-described embodiment is used to facilitate the understanding of the invention and does not limit the invention. Thus, the components disclosed in the above-described embodiment include all modifications in design and equivalents belonging to the technical scope of the invention.

In the above-described embodiment, the first conductive path 21 has both the first conductor portion 211 and the first intervening portion 212, but the invention is not particularly limited to this. The first conductive path 21 may have only one of the first conductor portion 211 or the first intervening portion 212. Similarly, the second conductive path 22 may have only one of the second conductor portion 221 or the second intervening portion 222.

In a case where the conductive body 20 does not require excellent resistance characteristics, the intermediate body 50 (refer to Fig. 19A) before compression may be used as the wiring board. In this case, the sintered body 43 corresponds to an example of the conductive body in the invention.

### EXPLANATIONS OF LETTERS OR NUMERALS

- 1, 1B: WIRING BOARD
- 10 to 10d: SUPPORT BODY
- 101: UPPER FACE
- 102: LOWER FACE
- 11: WOVEN FABRIC
- 12: WARP YARN
- 121: INSULATING FIBER
- 13: WEFT YARN
- 131: INSULATING FIBER
- 14: BASKET HOLE
- 15: SECOND RESIN LAYER
- 16: INSULATING SHEET
- 17: THIRD RESIN LAYER
- 20 to 20c: CONDUCTIVE BODY
- 201: WIRING PORTION
- 202, 203: LAND PORTION
- 204: WIRING PORTION
- 205, 206: LAND PORTION
- 21, 21b: FIRST CONDUCTIVE PATH
- 211: FIRST CONDUCTOR PORTION
- 212: FIRST INTERVENING PORTION
- 213, 214: CONDUCTIVE LAYER
- 22, 22b: SECOND CONDUCTIVE PATH
- 221: SECOND CONDUCTOR PORTION
- 222: SECOND INTERVENING PORTION
- 223, 224: CONDUCTIVE LAYER
- 30, 30c: FIRST INSULATING LAYER
- 31 to 34: WINDOW PORTION
- 41A, 41B: METAL OXIDE INK
- 42A, 42B: METAL OXIDE-CONTAINING PORTION
- 43: SINTERED BODY
- 44 to 47: MASK
- 48: LIQUID RESIN
- 50: INTERMEDIATE BODY
- 60: LIGHT SOURCE
- 71, 72: COMPRESSION ROLLER
- 141A, 141B: CONDUCTIVE INK
- 143A, 143B: FIRED BODY
- 144 to 147: MASK
- 148: LIQUID RESIN
- 149: RESIN SHEET
- 160: HEAT SOURCE

## Claims

1. A wiring board comprising:
a support body including at least one woven fabric woven from weaving yarns each formed by bundling insulating fibers; and
a conductive body supported by the support body, wherein
the conductive body includes a first conductive path which is provided on a first main face of the support body and extends in a planar direction of the first main face, and
the first conductive path has at least one of a first conductor portion and a first intervening portion, the first conductor portion existing in a basket hole of the woven fabric, and the first intervening portion existing in a gap between the insulating fibers.

2. The wiring board according to claim 1, wherein
the conductive body includes a second conductive path which is provided on a second main face of the support body and extends in a planar direction of the second main face,
the second conductive path has:
a second conductor portion which exists in the basket hole of the woven fabric; and
a second intervening portion which exists in a gap between the insulating fibers,
at least a portion of the first conductor portions and at least a portion of the second conductor portions are integrated with each other or bonded to each other, and
the first conductive path and the second conductive path are electrically connected to each other via the first conductor portion and the second conductor portion.

3. The wiring board according to claim 1 or 2, wherein
the weaving yarns include:
warp yarns which extend in a first direction; and
weft yarns which are weaving yarns of which type is the same as or different from a type of the warp yarns and extends in a second direction intersecting the first direction.

4. The wiring board according to any one of claims 1 to 3, further comprising a first insulating layer which covers the conductive body and exists in the support body.

5. The wiring board according to claim 4, wherein
the first insulating layer has a window portion which exposes a portion of the conductive body to an outside.

6. The wiring board according to any one of claims 1 to 5, wherein
the wiring board includes a second insulating layer which closes the basket hole from at least one of the second main face side and the first main face side of the support body.

7. The wiring board according to any one of claims 1 to 5, wherein
the support body has a third insulating layer which is provided so as to extend in the interior of the support body and closes the basket hole.

8. A method of manufacturing a wiring board, comprising:
a first process of preparing a support body including at least one woven fabric woven from weaving yarns each formed by bundling insulating fibers; and
a second process of supporting a conductive body by the support body, wherein
the second process includes:
a first step of forming a precursor containing at least one of metal particles and metal oxide particles on the support body by coating a dispersion liquid containing at least one of the metal particles and the metal oxide particles on at least one of a first main face and a second main face of the support body; and
a second step of forming a sintered body having conductivity by irradiating the precursor with pulsed electromagnetic waves, and
the first step includes forming the precursor so that the precursor exists in at least one of a basket hole of the woven fabric and a gap between the insulating fibers.

9. A method of manufacturing a wiring board, comprising:
a first process of preparing a support body including at least one woven fabric woven from weaving yarns each formed by bundling insulating fibers; and
a second process of supporting a conductive body by the support body, wherein
the second process includes:
a first step of coating a conductive ink containing conductive particles and a binder resin on at least one of a first main face and a second main face of the support body; and
a second step of forming a fired body having conductivity by applying thermal energy to the conductive ink, and
the first step includes coating the conductive ink so that the conductive ink exists in at least one of a basket hole of the woven fabric and a gap between the insulating fibers.

10. The method of manufacturing a wiring board according to claim 8 or 9, wherein
the weaving yarns include:
warp yarns which extend in a first direction; and
weft yarns which are weaving yarns of which type is the same as or different from a type of the warp yarns and extends in a second direction intersecting the first direction.

11. The method of manufacturing a wiring board according to claim 8, wherein
the second process includes a third step of compressing the sintered body.

12. The method of manufacturing a wiring board according to any one of claims 8 to 11, further comprising a third process of forming a first insulating layer which covers the conductive body and exists in the support body.

13. The method of manufacturing a wiring board according to claim 12, wherein
the first insulating layer has a window portion which exposes a portion of the conductive body to an outside.

14. The method of manufacturing a wiring board according to any one of claims 8 to 13, wherein
the first process includes forming a second insulating layer on the support body, the second insulating layer closing the basket hole from at least one of the second main face side and the first main face side of the support body.

15. The method of manufacturing a wiring board according to any one of claims 8 to 14, wherein
the first process includes forming a third insulating layer in the support body, the third insulating layer being provided so as to extend in the interior of the support body and closing the basket hole.
